(19) **Europäisches Patentamt / European Patent Office / Office européen des brevets**

(11) **EP 2 805 324 B1**

(12) **EUROPEAN PATENT SPECIFICATION**

(45) Date of publication and mention
of the grant of the patent:
**19.04.2017 Bulletin 2017/16**

(21) Application number: **13874853.8**

(22) Date of filing: **29.07.2013**

(51) Int Cl.:
**G10L 19/12** *(2013.01)*

(86) International application number:
**PCT/CN2013/080268**

(87) International publication number:
**WO 2014/124577 (21.08.2014 Gazette 2014/34)**

(54) **SYSTEM AND METHOD FOR MIXED CODEBOOK EXCITATION FOR SPEECH CODING**

SYSTEM UND VERFAHREN FÜR GEMISCHTE CODEBUCHANREGUNG ZUR SPRACHCODIERUNG

SYSTÈME ET PROCÉDÉ POUR L'EXCITATION D'UN GUIDE MIXTE DE CODIFICATION POUR CODAGE DE LA PAROLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.02.2013 US 201313768814**

(43) Date of publication of application:
**26.11.2014 Bulletin 2014/48**

(60) Divisional application:
**17160978.7**

(73) Proprietor: **Huawei Technologies Co., Ltd.
Longgang District
Shenzhen, Guangdong 518129 (CN)**

(72) Inventor: **GAO, Yang
Mission Viejo, California 92692 (US)**

(74) Representative: **Kreuz, Georg Maria
Huawei Technologies Duesseldorf GmbH
Riesstrasse 8
80992 München (DE)**

(56) References cited:
**CN-A- 101 557 367     CN-A- 102 006 144
US-A1- 2006 253 421     US-A1- 2011 051 938**

• **DE LAMARE R C ET AL: "Strategies to improve the performance of very low bit rate speech coders and application to a variable rate 1.2 kb/s codec", IEE PROCEEDINGS: VISION, IMAGE AND SIGNAL PROCESSING, INSTITUTION OF ELECTRICAL ENGINEERS, GB, vol. 152, no. 1, 28 February 2005 (2005-02-28), pages 74-86, XP006023467, ISSN: 1350-245X, DOI: 10.1049/IP-VIS:20051189**

**Description**

TECHNICAL FIELD

The present invention is generally in the field of signal coding. In particular, the present invention is in the field of low bit rate speech coding.

BACKGROUND

Traditionally, all parametric speech coding methods make use of the redundancy inherent in the speech signal to reduce the amount of information that must be sent and to estimate the parameters of speech samples of a signal at short intervals. This redundancy primarily arises from the repetition of speech wave shapes at a quasi-periodic rate, and the slow changing spectral envelop of speech signal.

The redundancy of speech waveforms may be considered with respect to several different types of speech signal, such as voiced and unvoiced. For voiced speech, the speech signal is essentially periodic; however, this periodicity may be variable over the duration of a speech segment and the shape of the periodic wave usually changes gradually from segment to segment. A low bit rate speech coding could greatly benefit from exploring such periodicity. The voiced speech period is also called pitch, and pitch prediction is often named Long-Term Prediction (LTP). As for unvoiced speech, the signal is more like a random noise and has a smaller amount of predictability.

In either case, parametric coding may be used to reduce the redundancy of the speech segments by separating the excitation component of speech signal from the spectral envelope component. The slowly changing spectral envelope can be represented by Linear Prediction Coding (LPC), also known as Short-Term Prediction (STP). A low bit rate speech coding could also benefit from exploring such a Short-Term Prediction. The coding advantage arises from the slow rate at which the parameters change. Yet, it is rare for the parameters to be significantly different from the values held within a few milliseconds. Accordingly, at the sampling rate of 8 kHz, 12.8 kHz or 16 kHz, the speech coding algorithm is such that the nominal frame duration is in the range of ten to thirty milliseconds, where a frame duration of twenty milliseconds is most common. In more recent well-known standards such as G.723.1, G.729, G.718, EFR, SMV, AMR, VMR-WB or AMR-WB, the Code Excited Linear Prediction Technique ("CELP") has been adopted, which is commonly understood as a technical combination of Coded Excitation, Long-Term Prediction and Short-Term Prediction. Code-Excited Linear Prediction (CELP) Speech Coding is a very popular algorithm principle in speech compression area although the details of CELP for different CODECs differ significantly.

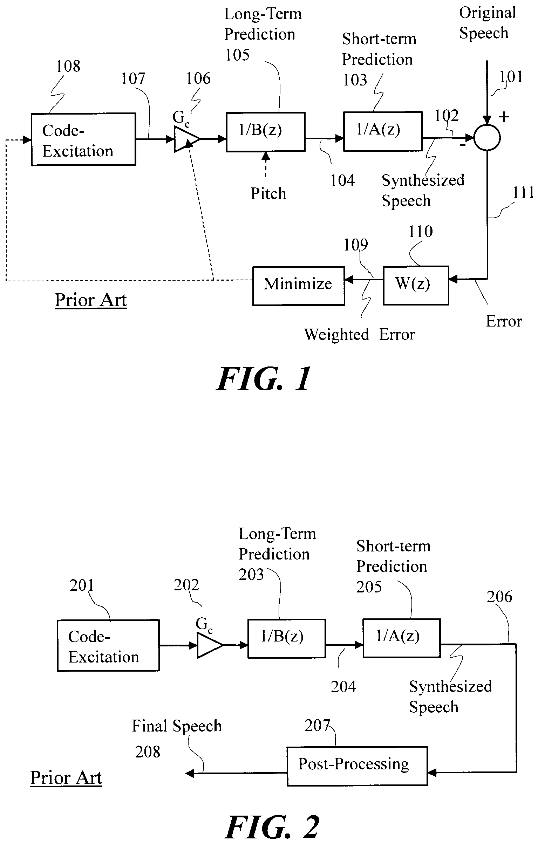

FIG. 1 illustrates a conventional CELP encoder where weighted error 109 between synthesized speech 102 and original speech 101 is minimized often by using a so-called analysis-by-synthesis approach. W(z) is an error weighting filter 110, 1/B(z) is a long-term linear prediction filter 105, and 1/A(z) is a short-term linear prediction filter 103. The coded excitation 108, which is also called fixed codebook excitation, is scaled by gain Gc 106 before going through the linear filters. The short-term linear filter 103 is obtained by analyzing the original signal 101 and represented by a set of coefficients:

$$A(z) \quad = \quad \sum_{i=1}^{P} 1 + a_i \cdot z^{-i} \quad , i = 1, 2, \dots, P \qquad . \tag{1}$$

The weighting filter 110 is somehow related to the above short-term prediction filter. A typical form of the weighting filter is:

$$W(z) \quad = \quad \frac{A(z/\alpha)}{A(z/\beta)} \quad , \tag{2}$$

where $\beta < \alpha$, $0 < \beta < 1$, $0 < \alpha \leq 1$. In the standard codec ITU-T G.718, the perceptual weighting filter has the following form:

$$W(z) = A(z/\gamma_1) H_{de-emph}(z) = A(z/\gamma_1)/(1 - \beta_1 z^{-1}) \, , \tag{3}$$

where,

$$H_{de-emph}(z) \quad = \quad \frac{1}{1-\beta_1 z^{-1}} \tag{4}$$

and $\beta_1$ is equal to 0.68.

The long-term prediction 105 depends on pitch and pitch gain. A pitch may be estimated, for example, from the original signal, residual signal, or weighted original signal. The long-term prediction function in principal may be expressed as

$$B(z) \quad = \quad 1 \quad - \quad \beta \cdot z^{-Pitch}. \tag{5}$$

The coded excitation 108 normally comprises a pulse-like signal or noise-like signal, which are mathematically constructed or saved in a codebook. Finally, the coded excitation index, quantized gain index, quantized long-term prediction parameter index, and quantized short-term prediction parameter index are transmitted to the decoder.

FIG. 2 illustrates an initial decoder that adds a post-processing block 207 after synthesized speech 206. The decoder is a combination of several blocks that are coded excitation 201, excitation gain 202, long-term prediction 203, short-term prediction 205 and post-processing 207. Every block except post-processing block 207 has the same definition as described in the encoder of FIG. 1. Post-processing block 207 may also include short-term post-processing and long-term post-processing.

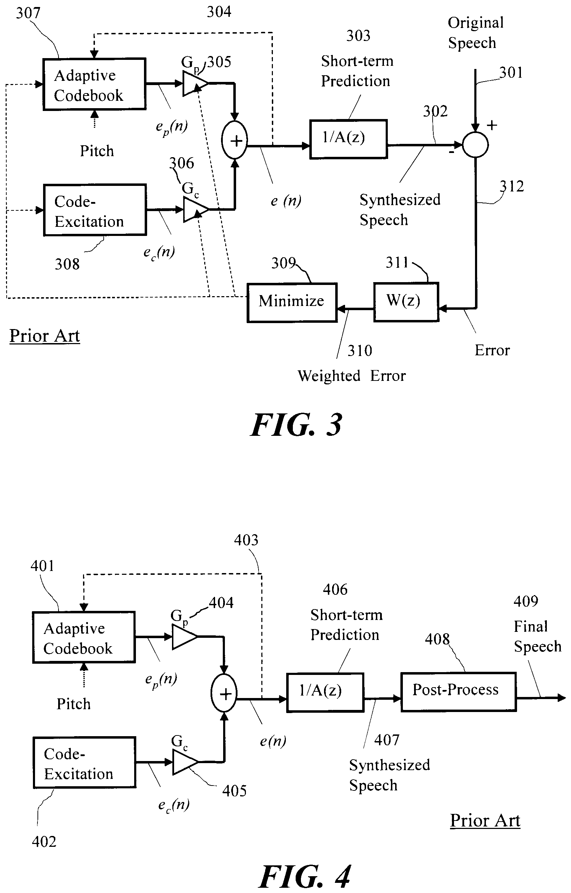

FIG. 3 shows a basic CELP encoder that realizes the long-term linear prediction by using adaptive codebook 307 containing a past synthesized excitation 304 or repeating past excitation pitch cycle at pitch period. Pitch lag may be encoded in integer value when it is large or long. And pitch lag is may be encoded in more precise fractional value when it is small or short. The periodic information of pitch is employed to generate the adaptive component of the excitation. This excitation component is then scaled by gain Gp 305 (also called pitch gain). The second excitation component is generated by coded-excitation block 308, which is scaled by gain $G_c$ 306. $G_c$ is also referred to as fixed codebook gain, since the coded-excitation often comes from a fixed codebook. The two scaled excitation components are added together before going through the short-term linear prediction filter 303. The two gains (Gp and $G_c$) are quantized and then sent to a decoder.

FIG. 4 illustrates a conventional decoder corresponding to the encoder in FIG. 3, which adds a post-processing block 408 after a synthesized speech 407. This decoder is similar to FIG. 2 with the addition of adaptive codebook 307. The decoder is a combination of several blocks, which are coded excitation 402, adaptive codebook 401, short-term prediction 406, and post-processing 408. Every block except post-processing block 408 has the same definition as described in the encoder of FIG. 3. Post-processing block 408 may further include of short-term post-processing and long-term post-processing.

Long-Term Prediction plays very important role for voiced speech coding because voiced speech has a strong periodicity. The adjacent pitch cycles of voiced speech are similar each other, which means mathematically that pitch gain Gp in the following excitation expression is high or close to 1,

$$e(n) \quad = \quad G_p \cdot e_p(n) \quad + \quad G_c \cdot e_c(n), \tag{6}$$

where $e_p(n)$ is one subframe of sample series indexed by n, coming from the adaptive codebook 307 which comprises the past excitation 304; ep(n) may be adaptively low-pass filtered as low frequency area is often more periodic or more harmonic than high frequency area; $e_c(n)$ is from the coded excitation codebook 308 (also called fixed codebook) which is a current excitation contribution; and $e_c(n)$ may also be enhanced using high pass filtering enhancement, pitch enhancement, dispersion enhancement, formant enhancement, and the like. For voiced speech, the contribution of $e_p(n)$ from the adaptive codebook may be dominant and the pitch gain Gp 305 may be a value of about 1. The excitation is usually updated for each subframe. A typical frame size is 20 milliseconds and typical subframe size is 5 milliseconds. DE LAMARE R C ET AL: "Strategies to improve the performance of very low bit rate speech coders and application to a variable rate 1.2 kb/s codex", IEE PROCEEDINGS: VISION, IMAGE AND SIGNAL PROCESSING, INSTITUTION OF ELECTRICAL ENGINEERS, GB, vol. 152, no. 1 28 February 2005 (2005-02-28), pages 74-86, XP006023467, ISSN:1350-245X, DOI: 10.1049/IP-VIS:20051189, discloses a mixed multiband excitation. A sub-band analysis filter splits the speech spectrum into the following frequency bands: 0-1KHz, 1-2KHz and 2-4 KHz, and the split subbands are determined being voiced or unvoiced. A proposed excitation codebook comprises four different mixed-voiced excitations (0-3) and four unvoiced excitation (4-7) entries. A mixed excitation m(n) used in this work consists in the application of a pulse excitation p(n) filtered in the chosen subbands and summed to filtered white noise excitation w(n) in the remaining subbands.

## SUMMARY OF THE INVENTION

In accordance with an embodiment, a method of CELP encoding an audio/a speech signal includes determining a mixed codebook vector based on an incoming audio/speech signal, the mixed codebook vector comprising a sum of a first codebook entry from a first codebook and a second codebook entry from a second codebook. The method further includes generating an encoded audio signal based on the determined mixed codebook vector, and transmitting a coded excitation index of the determined mixed codebook vector.

According to a first aspect, an embodiment of the present invention provides a method of CELP encoding an audio/speech signal, the method comprising:

determining a mixed codebook vector based on an incoming audio/speech signal, the mixed codebook vector comprising a sum of a first codebook entry from a first codebook and a second codebook entry from a second codebook, wherein the first codebook comprises pulse-like entries and the second codebook comprises noise-like entries;

generating an encoded audio signal based on the determined mixed codebook vector; and

transmitting a coded excitation index of the determined mixed codebook vector, wherein the determining and generating are performed using a hardware-based audio encoder, wherein the first and second codebooks are fixed codebooks.

In a first possible implementation manner of the first aspect, wherein determining the mixed codebook vector comprises:

computing first correlations between a filtered target vector and filtered entries in the first codebook, wherein the filtered target vector is based on the incoming audio signal;
determining a first group of highest first correlations;
computing correlations between a filtered target vector and filtered entries in the second codebook;
determining a second group of highest second correlations; and
computing a first criterion function of combinations of the first and second groups, wherein the first criterion function comprises a function of one of the first group of highest first correlations, one of the second group of highest second correlations and an energy of corresponding entries from the first codebook and the second codebook.

With reference to the first possible implementation manner of the first aspect, in a second possible implementation manner, further comprising:

determining a third group of candidate correlations based on highest computed first criterion functions; and
selecting the mixed codebook vector based on applying a second criterion function to the third group, wherein the mixed codebook vector corresponds to codebook entries from the first codebook and the second codebook associated with a highest value of the second criterion function.

With reference to the second possible implementation manner of the first aspect, in a third possible implementation manner, wherein:

the first criterion function is

$$Q(i,j) = \frac{[\, R_{CB1}(i) + R_{CB2}(j)\,]^2}{E_{CB1}(i) + E_{CB2}(j)} \quad ; \quad i = 0,1,...,K_{CB1}^0 - 1 \quad ; \quad j = 0,1,...,K_{CB2}^0 - 1$$

,

where $R_{CB1}(i)$ is a correlation between the filtered target vector and an $i^{th}$ first entry of the first codebook, $R_{CB2}(j)$ is a correlation between the filtered target vector and a $j^{th}$ entry of the second codebook, $E_{CB1}(i)$ is an energy of the

$i^{th}$ entry of the first codebook and $E_{CB2}(i)$ is an energy of the $j^{th}$ entry of the second codebook, $K_{CB1}^0$ is a number of first codebook entries in the first group and $K_{CB2}^0$ is a number of second codebook entries in the second group; and the second criterion function is

$$Q_k \;=\; \frac{[\,R_{CB1}(i_k)+R_{CB2}(j_k)\,]^2}{E_{CB1}(i_k)+2\,\mathbf{z}_{CB1}(i_k)^T\mathbf{z}_{CB2}(j_k)+E_{CB2}(j_k)} \;\;,\;\; k=0,1,...,K-1 \;,$$

where $\mathbf{z}_{CB1}(i_k)$ is a filtered vector of the $i^{th}$ entry of the first codebook and $\mathbf{z}_{CB2}(j_k)$ is a filtered vector of the $j^{th}$ entry of the second codebook, and K is a number of entries in the third group.

With reference to the first possible implementation manner of the first aspect, in a fourth possible implementation manner, wherein selecting the mixed codebook vector based on a highest computed first criterion function.

With reference to the fourth possible implementation manner of the first aspect, in a fifth possible implementation manner, wherein the first criterion function is

$$Q(i,j)=\frac{[\,R_{CB1}(i)+R_{CB2}(j)\,]^2}{E_{CB1}(i)+E_{CB2}(j)} \;\;;\;\; i=0,1,...,K_{CB1}^0-1 \;\;;\;\; j=0,1,...,K_{CB2}^0-1$$

where $R_{CB1}(i)$ is a correlation between the filtered target vector and an $i^{th}$ first entry of the first codebook, $R_{CB2}(j)$ is a correlation between the filtered target vector and a $j^{th}$ entry of the second codebook, $E_{CB1}(i)$ is an energy of the $i^{th}$ entry of the first codebook and $E_{CB2}(i)$ is an energy of the $j^{th}$ entry of the second codebook, and $K_{CB1}^0$ is a number of first codebook entries in the first group and $K_{CB2}^0$ is a number of second codebook entries in the second group.

With reference to the first possible implementation manner of the first aspect, in a sixth possible implementation manner, further comprising calculating energies of the corresponding entries from the first codebook and the second codebook.

With reference to the first possible implementation manner of the first aspect, in an seventh possible implementation manner, wherein the energy of corresponding entries from the first codebook and the second codebook are stored in memory.

With reference to the first possible implementation manner of the first aspect, in a eighth possible implementation manner, wherein the first group comprises more entries than the second group.

In a ninth possible implementation manner of the first aspect, further comprising:

applying a first emphasis function to the first codebook entry; and
applying a second emphasis function to the second codebook entry.

With reference to the ninth possible implementation manner of the first aspect, in an tenth possible implementation manner, wherein:

the first emphasis function comprises a low pass filtering function; and
the second emphasis function comprises a high pass filtering function.

In a eleventh possible implementation manner of the first aspect, wherein the hardware-based audio encoder comprises a processor.

In a twelfth possible implementation manner of the first aspect, wherein the hardware-based audio encoder comprises dedicated hardware.

According to a second aspect, an embodiment of the present invention provides a system for CELP encoding an audio/speech signal, the system comprising:

a hardware-based audio coder configured to:

determine a mixed codebook vector based on an incoming audio/speech signal, the mixed codebook vector comprising a sum of a first codebook entry from a pulse-like codebook and a second codebook entry from a noise-like codebook, wherein the first and second codebooks are fixed codebooks;

generate an encoded audio/speech signal based on the determined mixed codebook vector; and

transmit a coded excitation index of the determined mixed codebook vector.

In a first possible implementation manner of the second aspect, wherein the hardware-based audio coder is further configured to:

compute first correlations between a filtered target vector and entries in the pulse-like codebook, wherein the filtered target vector is based on the incoming audio signal;

determine a first group of highest first correlations;

compute correlations between a filtered target vector and entries in the noise-like codebook;

determine a second group of highest second correlations; and

compute a first criterion function of combinations of first and second groups, wherein the first criterion function comprises a function of one of the first group of highest first correlations, one of the second group of highest second correlations and an energy of corresponding entries from the pulse-like codebook and the noise-like codebook.

With reference to the first possible implementation manner of the second aspect, in a second possible implementation manner, further comprising a memory configured to store values of the energy of corresponding entries from the pulse-like codebook and the noise-like codebook.

With reference to the first possible implementation manner of the second aspect, in a third possible implementation manner, wherein the hardware-based audio coder is further configured to select the mixed codebook vector based on a highest computed first criterion function.

With reference to the first possible implementation manner of the second aspect, in a fourth possible implementation manner, wherein the first criterion function is

$$Q(i,j) = \frac{[\, R_{CB1}(i) + R_{CB2}(j)\,]^2}{E_{CB1}(i) + E_{CB2}(j)} \quad ; \quad i = 0,1,...,K^0_{CB1} - 1 \quad ; \quad j = 0,1,...,K^0_{CB2} - 1$$

where $R_{CB1}(i)$ is a correlation between the filtered target vector and an $i^{th}$ first entry of the first codebook, $R_{CB2}(j)$ is a correlation between the filtered target vector and a $j^{th}$ entry of the second codebook, $E_{CB1}(i)$ is an energy of the $i^{th}$ entry of the first codebook and $E_{CB2}(i)$ is an energy of the $j^{th}$ entry of the second codebook, and $K^0_{CB1}$ is a number of first codebook entries in the first group and $K^0_{CB2}$ is a number of second codebook entries in the second group.

In a fifth possible implementation manner of the second aspect, wherein the hardware-based audio coder comprises a processor.

In a sixth possible implementation manner of the second aspect, wherein the hardware-based audio coder comprises dedicated hardware.

According to a third aspect, an embodiment of the present invention provides a fast search method of a mixed codebook for CELP encoding an audio/speech signal, the method comprising:

determining a mixed codebook vector based on an incoming audio/speech signal, the mixed codebook vector comprising a sum of a first codebook entry from a first codebook and a second codebook entry from a second codebook, wherein the first and second codebooks are fixed codebooks;

computing first correlations between a filtered target vector and filtered entries in the first codebook, wherein the filtered target vector is based on the incoming audio signal;

determining a first group of highest first correlations;

computing correlations between a filtered target vector and filtered entries in the second codebook;

determining a second group of highest second correlations;

computing a first criterion function of combinations of the first and second groups, wherein the first criterion function comprises a function of one of the first group of highest first correlations, one of the second group of highest second correlations and an energy of corresponding entries from the first codebook and the second codebook;

determining a third group of candidate correlations based on highest computed first criterion functions;

selecting the mixed codebook vector based on applying a second criterion function to the third group, wherein the mixed codebook vector corresponds to codebook entries from the first codebook and the second codebook associated with a highest value of the second criterion function;

generating an encoded audio signal based on the determined mixed codebook vector; and

transmitting a coded excitation index of the determined mixed codebook vector, wherein the determining and generating are performed using a hardware-based audio encoder

In a first possible implementation manner of the third aspect, wherein:

the first criterion function is

$$Q(i,j) = \frac{[R_{CB1}(i) + R_{CB2}(j)]^2}{E_{CB1}(i) + E_{CB2}(j)} \quad ; \quad i = 0,1,...,K_{CB1}^0 - 1 \quad ; \quad j = 0,1,...,K_{CB2}^0 - 1 \quad ,$$

where $R_{CB1}(i)$ is a correlation between the filtered target vector and an $i^{th}$ first entry of the first codebook, $R_{CB2}(j)$ is a correlation between the filtered target vector and a $j^{th}$ entry of the second codebook, $E_{CB1}(i)$ is an energy of the $i^{th}$ entry of the first codebook and $E_{CB2}(i)$ is an energy of the $j^{th}$ entry of the second codebook, $K_{CB1}^0$ is a number of first codebook entries in the first group and $K_{CB2}^0$ is a number of second codebook entries in the second group; and the second criterion function is

$$Q_k = \frac{[R_{CB1}(i_k) + R_{CB2}(j_k)]^2}{E_{CB1}(i_k) + 2\,\mathbf{z}_{CB1}(i_k)^T \mathbf{z}_{CB2}(j_k) + E_{CB2}(j_k)} \quad , \quad k = 0,1,...,K-1 \quad ,$$

where $\mathbf{z}_{CB1}(i_k)$ is a filtered vector of the $i^{th}$ entry of the first codebook and $\mathbf{z}_{CB2}(j_k)$ is a filtered vector of the $j^{th}$ entry of the second codebook, and K is a number of entries in the third group.

In a second possible implementation manner of the third aspect, wherein the first codebook comprises a pulse-like codebook and the second codebook comprises a noise-like codebook.

BRIEF DESCRIPTION OF THE DRAWINGS

For a more complete understanding of the present invention, and the advantages thereof, reference is now made to the following descriptions taken in conjunction with the accompanying drawings, in which:

FIG. 1 illustrates a conventional CELP speech encoder;

FIG. 2 illustrates a conventional CELP speech decoder;

FIG. 3 illustrates a conventional CELP encoder that utilizes an adaptive codebook;

FIG. 4 illustrates a conventional CELP speech decoder that utilizes an adaptive codebook;

FIG. 5 illustrates a FCB structure that contains noise-like candidate vectors for constructing a coded excitation;

FIG. 6 illustrates a FCB structure that contains pulse-like candidate vectors for constructing a coded excitation;

FIG. 7 illustrates an embodiment structure of the pulse-noise mixed FCB;

FIG. 8 illustrates an embodiment structure of a pulse-noise mixed FCB;

FIG. 9 illustrates a general structure of an embodiment pulse-noise mixed FCB;

FIG. 10 illustrates a further general structure of an embodiment pulse-noise mixed FCB;

FIG. 11 illustrates a further general structure of an embodiment pulse-noise mixed FCB;

FIG. 12 illustrates a more general structure of an embodiment mixed FCB;

FIG. 13 illustrates a block diagram of an excitation coding system;

FIG. 14 illustrates a block diagram of an embodiment mixed codebook-based excitation coding system;

FIGs. 15a-b illustrate flowcharts of embodment methods; and

FIG. 16 illustrates an embodiment communication system.

Corresponding numerals and symbols in different figures generally refer to corresponding parts unless otherwise indicated. The figures are drawn to clearly illustrate the relevant aspects of the preferred embodiments and are not necessarily drawn to scale. To more clearly illustrate certain embodiments, a letter indicating variations of the same structure, material, or process step may follow a figure number.

DETAILED DESCRIPTION OF ILLUSTRATIVE EMBODIMENTS

The making and using of the presently preferred embodiments are discussed in detail below. It should be appreciated, however, that the present invention provides many applicable inventive concepts that can be embodied in a wide variety of specific contexts. The specific embodiments discussed are merely illustrative of specific ways to make and use the invention, and do not limit the scope of the invention.

The present invention will be described with respect to embodiments in a specific context, namely a CELP-based audio encoder and decoder. It should be understood that embodiments of the present invention may be directed toward other systems such as.

As already mentioned, CELP is mainly used to encode speech signal by benefiting from specific human voice characteristics or human vocal voice production model. CELP algorithm is a very popular technology that has been used in various ITU-T, MPEG, 3GPP, and 3GPP2 standards. In order to encode speech signal more efficiently, a speech signal may be classified into different classes and each class is encoded in a different way. For example, in some standards such as G.718, VMR-WB or AMR-WB, a speech signal is classified into UNVOICED, TRANSITION, GENERIC, VOICED, and NOISE. For each class, a LPC or STP filter is always used to represent spectral envelope; but the excitation to the LPC filter may be different. UNVOICED and NOISE may be coded with a noise excitation and some excitation enhancement. TRANSITION may be coded with a pulse excitation and some excitation enhancement without using adaptive codebook or LTP. GENERIC may be coded with a traditional CELP approach such as Algebraic CELP used in G.729 or AMR-WB, in which one 20 ms frame contains four 5 ms subframes, both the adaptive codebook excitation component and the fixed codebook excitation component are produced with some excitation enhancements for each subframe, pitch lags for the adaptive codebook in the first and third subframes are coded in a full range from a minimum pitch limit PIT_MIN to a maximum pitch limit PIT_MAX, and pitch lags for the adaptive codebook in the second and fourth subframes are coded differentially from the previous coded pitch lag. A VOICED class signal may be coded slightly differently from GNERIC, in which pitch lag in the first subframe is coded in a full range from a minimum pitch limit PIT_MIN to a maximum pitch limit PIT_MAX, and pitch lags in the other subframes are coded differentially from the previous coded pitch lag.

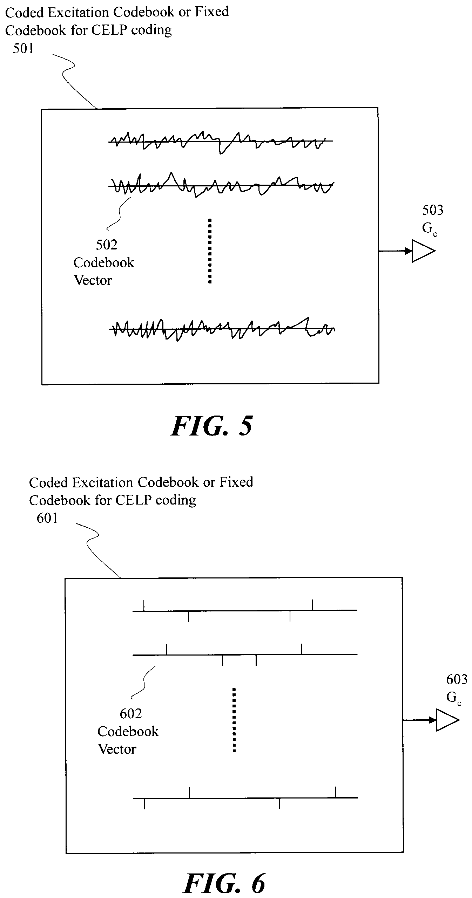

Code-Excitation block 402 in FIG. 4 and 308 in FIG. 3 show the location of Fixed Codebook (FCB) for a general CELP coding; a selected code vector from FCB is scaled by a gain often noted as $G_c$. For NOISE or UNVOICED class signal, an FCB containing noise-like vectors may be the best structure from perceptual quality point of view, because the adaptive codebook contribution or LTP contribution would be small or non-existant, and because the main excitation contribution relies on the FCB component for NOISE or UNVOICED class signal. In this case, if a pulse-like FCB such as that shown in FIG. 6 is used, the output synthesized speech signal could sound spiky due to the many zeros found in the code vector selected from a pulse-like FCB designed for low bit rate coding. FIG. 5 illustrates a FCB structure that contains noise-like candidate vectors for constructing a coded excitation. 501 is a noise-like FCB; 502 is a noise-like code vector; and a selected code vector is scaled by a gain 503.

For a VOICED class signal, a pulse-like FCB yields a higher quality output than a noise-like FCB from perceptual point of view, because the adaptive codebook contribution or LTP contribution is dominant for the highly periodic VOICED class signal and the main excitation contribution does not rely on the FCB component for the VOICED class signal. In this case, if a noise-like FCB is used, the output synthesized speech signal may sound noisy or less periodic, since it is more difficult to have good waveform matching by using the code vector selected from the noise-like FCB designed for low bit rate coding. FIG. 6 illustrates a FCB structure that contains pulse-like candidate vectors for constructing a coded excitation. 601 represents a pulse-like FCB, and 602 represents a pulse-like code vector. A selected code vector is scaled by a gain 603.

Most CELP codecs work well for normal speech signals; however low bit rate CELP codecs could fail in the presence of an especially noisy speech signal or for a GENERIC class signal. As already described, a noise-like FCB may be the best choice for NOISE or UNVOICED class signal and a pulse-like FCB may be the best choice for VOICED class signal. The GENERIC class is between VOICED class and UNVOICED class. Statistically, LTP gain or pitch gain for GENERIC class may be lower than VOICED class but higher than UNVOICED class. The GENERIC class may contain both a noise-like component signal and periodic component signal. At low bit rates, if a pulse-like FCB is used for GENERIC class signal, the output synthesized speech signal may still sound spiky since there are a lot of zeros in the code vector selected from the pulse-like FCB designed for low bit rate coding. For example, when an 6800 bps or 7600 bps codec encodes a speech signal sampled at 12.8 kHz, a code vector from the pulse-like codebook may only afford to have two non-zero pulses, thereby causing a spiky sound for noisy speech. If a noise-like FCB is used for GENERIC class signal, the output synthesized speech signal may not have a good enough waveform matching to generate a periodic component, thereby causing noisy sound for clean speech. Therefore, a new FCB structure between noise-like and pulse-like may be needed for GENERIC class coding at low bit rates.

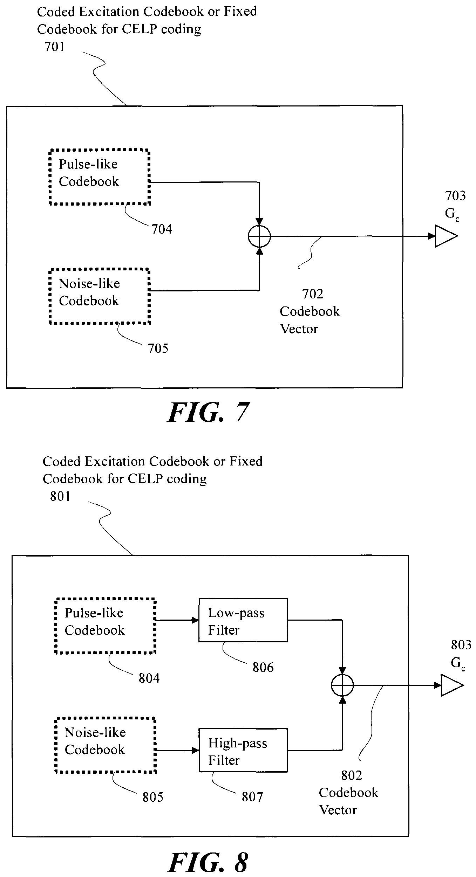

One of the solutions for having better low-bit rates speech coding for GENERIC class signal is to use a pulse-noise mixed FCB instead of a pulse-like FCB or a noise-like FCB. FIG. 7 illustrates an embodiment structure of the pulse-noise mixed FCB. 701 indicates the whole pulse-noise mixed FCB. The selected code vector 702 is generated by combining (adding) a vector from a pulse-like sub-codebook 704 and a vector from a noise-like sub-codebook 705. The selected code vector 702 is then scaled by the FCB gain $G_c$ 703. For example, 6 bits are assigned to the pulse-like sub-codebook 704, in which 5 bits are to code one pulse position and 1 bit is to code a sign of the pulse-like vectors; 6 bits are assigned to the noise-like sub-codebook 705, in which 5 bits are to code 32 different noise-like vectors and 1 bit is to code a sign of the noise-like vectors.

FIG. 8 illustrates an embodiment structure of a pulse-noise mixed FCB 801. As a code vector from a pulse-noise mixed FCB is a combination of a vector from a pulse-like sub-codebook and a vector from a noise-like sub-codebook, different enhancements may be applied respectively to the vector from the pulse-like sub-codebook and the vector from the noise-like sub-codebook. For example, a low pass filter can be applied to the vector from the pulse-like sub-codebook; this is because low frequency area is often more periodic than high frequency area and low frequency area needs more pulse-like excitation than high frequency area; a high pass filter can be applied to the vector from the noise-like sub-codebook; this is because high frequency area is often more noisy than low frequency area and high frequency area needs more noise-like excitation than low frequency area. Selected code vector 802 is generated by combining (adding) a low-pass filtered vector from a pulse-like sub-codebook 804 and a high-pass filtered vector from a noise-like sub-codebook 805. 806 indicates the low-pass filter that may be fixed or adaptive. For example, a first-order filter $(1 + 0.4\ Z^{-1})$ is used for a GENERIC speech frame close to voiced speech signal and one-order filter $(1 + 0.3\ Z^{-1})$ is used for a GENERIC speech frame close to unvoiced speech signal. 807 indicates the high-pass filter which can be fixed or adaptive; for example, one-order filter $(1 - 0.4\ Z^{-1})$ is used for a GENERIC speech frame close to unvoiced speech signal and one-order filter $(1 - 0.3\ Z^{-1})$ is used for a GENERIC speech frame close to voiced speech signal. Enhancement filters 806 and 807 normally do not spend bits to code the filter coefficients, and the coefficients of the enhancement filters may be adaptive to available parameters in both encoder and decoder. The selected code vector 802 is then scaled by the FCB gain $G_c$ 803. As the example given for FIG. 8, if 12 bits are available to code the pulse-noise mixed FCB, in FIG. 8, 6 bits can be assigned to the pulse-like sub-codebook 804, in which 5 bits are to code one pulse position and 1 bit is to code a sign of the pulse-like vectors. For example, 6 bits can be assigned to the noise-like sub-codebook 805, in which 5 bits are to code 32 different noise-like vectors and 1 bit is to code a sign of the noise-like vectors.

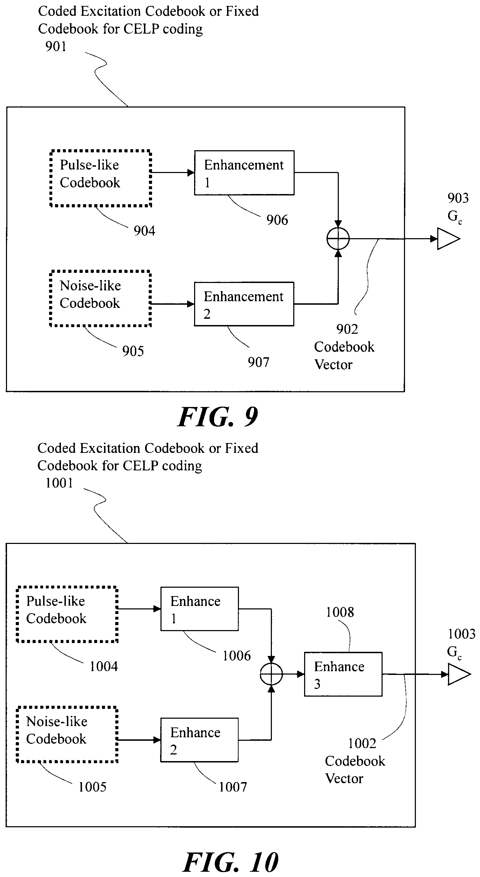

FIG. 9 illustrates a more general structure of an embodiment pulse-noise mixed FCB 901. As a code vector from the pulse-noise mixed FCB in FIG. 9 is a combination of a vector from a pulse-like sub-codebook and a vector from a noise-like sub-codebook, different enhancements may be applied respectively to the vector from the pulse-like sub-codebook and the vector from the noise-like sub-codebook. For example, an enhancement including low pass filter, high-pass filter, pitch filter, and/or formant filter can be applied to the vector from the pulse-like sub-codebook; similarly, an enhancement including low pass filter, high-pass filter, pitch filter, and/or formant filter can be applied to the vector from the noise-like sub-codebook. Selected code vector 902 is generated by combining (adding) an enhanced vector from a pulse-like sub-codebook 904 and an enhanced vector from a noise-like sub-codebook 905. 906 indicates the enhancement for the pulse-like vectors, which can be fixed or adaptive. 907 indicates the enhancement for the noise-like vectors, which can also be fixed or adaptive. The enhancements 906 and 907 normally do not spend bit to code the enhancement parameters. The parameters of the enhancements can be adaptive to available parameters in both encoder and decoder. The selected code vector 902 is then scaled by the FCB gain $G_c$ 903. As the example given for FIG. 9, if 12 bits are available to code the pulse-noise mixed FCB in FIG. 9, 6 bits can be assigned to the pulse-like sub-codebook 904, in which 5 bits are to code one pulse position and 1 bit is to code a sign of the pulse-like vectors; and 6 bits can be assigned to the noise-like sub-codebook 905, in which 5 bits are to code 32 different noise-like vectors and 1 bit is to code a sign of the noise-like vectors.

FIG. 10 illustrates a further general structure of an embodiment pulse-noise mixed FCB. As a code vector from the pulse-noise mixed FCB in FIG. 10 is a combination of a vector from a pulse-like sub-codebook and a vector from a noise-like sub-codebook, different enhancements can be applied respectively to the vector from the pulse-like sub-codebook and the vector from the noise-like sub-codebook. For example, a first enhancement including low pass filter, high-pass filter, pitch filter, and/or formant filter can be applied to the vector from the pulse-like sub-codebook; similarly, a second enhancement including low pass filter, high-pass filter, pitch filter, and/or formant filter can be applied to the vector from the noise-like sub-codebook. 1001 indicates the whole pulse-noise mixed FCB. The selected code vector 1002 is generated by combining (adding) a first enhanced vector from a pulse-like sub-codebook 1004 and a second enhanced vector from a noise-like sub-codebook 1005. 1006 indicates the first enhancement for the pulse-like vectors, which can be fixed or adaptive. 1007 indicates the second enhancement for the noise-like vectors, which can also be fixed or adaptive. 1008 indicates the third enhancement for the pulse-noise combined vectors, which can also be fixed or adaptive. The enhancements 1006, 1007, and 1008 normally do not spend bits to code the enhancement parameters; as the parameters of the enhancements can be adaptive to available parameters in both encoder and decoder. The selected code vector 1002 is then scaled by the FCB gain $G_c$ 1003. As the example given for FIG.10, if 12 bits are available to code the pulse-noise mixed FCB in FIG. 10, 6 bits can be assigned to the pulse-like sub-codebook 1004, in which 5 bits are to code one pulse position and 1 bit is to code a sign of the pulse-like vectors; 6 bits can be assigned to the noise-like sub-codebook 1005, in which 5 bits are to code 32 different noise-like vectors and 1 bit is to code a sign of the noise-like vectors. If the FCB gain $G_c$ is signed, only one of the sign for the pulse-like vectors and the sign for the noise-like vectors needs to be coded.

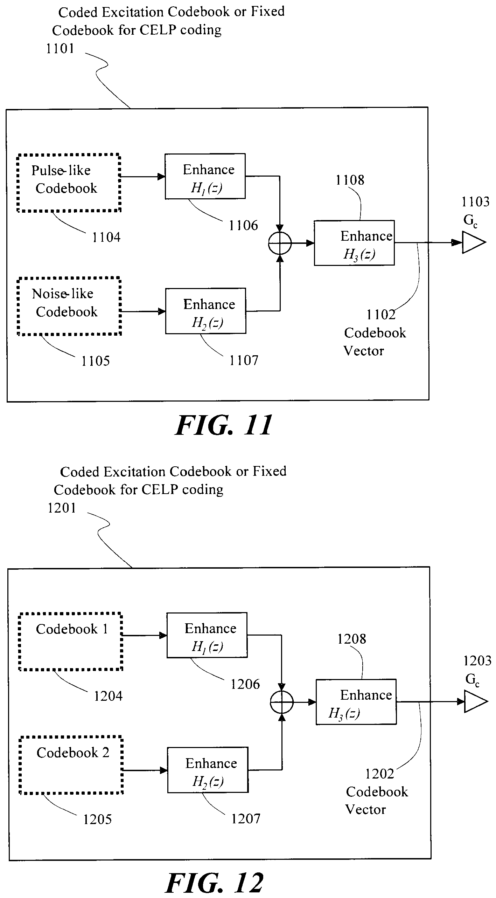

FIG. 11 illustrates a further general structure of an embodiment pulse-noise mixed FCB. As a code vector from the pulse-noise mixed FCB in FIG. 11 is a combination of a vector from a pulse-like sub-codebook and a vector from a noise-like sub-codebook, different enhancements can be applied respectively to the vector from the pulse-like sub-codebook and the vector from the noise-like sub-codebook. For example, a first enhancement H1(z) including low pass filter, high-pass filter, pitch filter, and/or formant filter can be applied to the vector from the pulse-like sub-codebook; similarly, a second enhancement H2(z) including low pass filter, high-pass filter, pitch filter, and/or formant filter can be applied to the vector from the noise-like sub-codebook. 1101 indicates the whole pulse-noise mixed FCB. The selected code vector 1102 is generated by combining (adding) a first enhanced vector from a pulse-like sub-codebook 1104 and a second enhanced vector from a noise-like sub-codebook 1105. 1106 indicates the first enhancement H1(z) for the pulse-like vectors, which can be fixed or adaptive. 1107 indicates the second enhancement H2(z) for the noise-like vectors, which can also be fixed or adaptive. 1108 indicates the third enhancement H3(z) for the pulse-noise combined vectors, which can also be fixed or adaptive. Normally no bits are spent to code the enhancement parameters of the enhancements 1106, 1107, and 1108; as the parameters of the enhancements can be adaptive to available parameters in both encoder and decoder. Selected code vector 1102 is then scaled by the FCB gain $G_c$ 1103. As the example given for FIG.11, if 12 bits are available to code the pulse-noise mixed FCB in FIG.11, 6 bits can be assigned to the pulse-like sub-codebook 1104, in which 5 bits are to code one pulse position and 1 bit is to code a sign of the pulse-like vectors; 6 bits can be assigned to the noise-like sub-codebook 1105, in which 5 bits are to code 32 different noise-like vectors and 1 bit is to code a sign of the noise-like vectors. If the FCB gain $G_c$ 1103 is signed, only one of the sign for the pulse-like vectors and the sign for the noise-like vectors needs to be coded.

FIG. 12 shows a more general structure of an embodiment mixed FCB. The main difference between FIG. 12 and FIG. 11 is that Codebook 1 in block 1204 may contain pulse-like or noise-like vectors and Codebook 2 in the block 1205 may also contain pulse-like or noise-like vectors; this means the mixed codebook can be any combination of pulse-like and/or noise-like vectors. As a code vector from the mixed FCB in FIG. 12 is a combination of a vector from Codebook 1 and a vector from Codebook 2, different enhancements may be applied respectively to the vector from the Codebook 1 and the vector from the Codebook 2. For example, an enhancement H1(z) including low pass filter, high-pass filter, pitch filter, and/or formant filter can be applied to the vector from the Codebook 1. Similarly, an enhancement H2(z) including low pass filter, high-pass filter, pitch filter, and/or formant filter can be applied to the vector from the Codebook 2. 1201 indicates the whole mixed FCB. The selected code vector 1202 is generated by combining (adding) an enhanced vector from Codebook 1 and an enhanced vector from Codebook 2. 1206 indicates the enhancement H1(z) for the vectors of Codebook 1, which can be fixed or adaptive. 1207 indicates the enhancement H2(z) for the vectors of Codebook 2, which may also be fixed or adaptive. 1208 indicates the third enhancement H3(z) for the combined vectors, which can also be fixed or adaptive. The enhancements 1206, 1207, and 1208 normally do not spend bits to code the enhancement parameters; as the parameters of the enhancements can be adaptive to available parameters in both encoder and decoder. The selected code vector 1202 is then scaled by the FCB gain $G_c$ 1203.

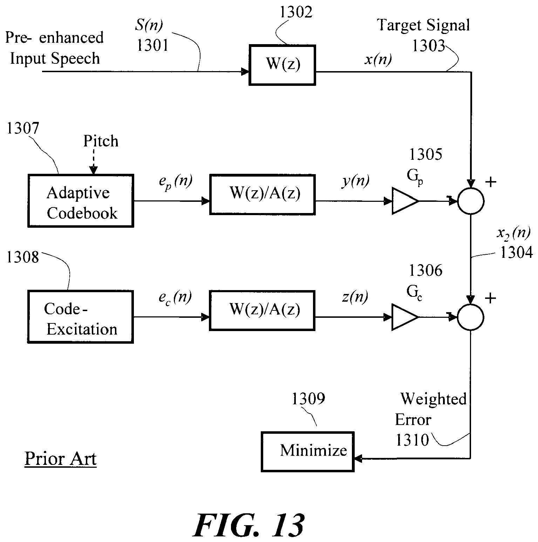

Suppose the fixed codebook structure is as shown in FIG. 11, and the excitation signal is coded per subframes of 64 samples, i.e., four times per frame; this section provides a fast searching approach for a pulse-noise mixed codebook. The principle of excitation coding is shown in a schematic diagram in FIG. 13, which is actually similar to the principle shown in FIG. 3. Theoretically, FIG. 3 allows a joint optimization of the adaptive codebook excitation component and the fixed codebook excitation component (i.e. code-excitation component). In practice, for reasons of simplicity, the adaptive codebook excitation component is often determined first and then the fixed codebook excitation component.

For each subframe, the LP residual is given by

$$r(n) \quad = \quad s(n) \quad + \quad \sum_{i=0}^{P} a_i \cdot s(n-i) \quad , \quad n = 0,1,...63$$

$$(7)$$

where s(n) is an input signal 1301 that is often pre-emphasized and used for wideband speech coding but not for narrow band speech coding. For example, the pre-emphasis filter can be

$$H_{emph}(z) \quad = \quad 1 - \beta_1 z^{-1}$$

$$(8)$$

and $\beta_1$ is equal to 0.68. Alternatively, $\beta_1$ may take on different values.

Target signal 1303 x(n) for the adaptive codebook 1307 search is may be computed by subtracting a zero-input response (not shown in FIG. 13) of the weighted synthesis filter W(z)/A(z) from the weighted pre-emphasized input signal which is obtained by filtering the input signal 1301 s(n) through the weighting filter 1302. This is performed on a sub frame basis. An equivalent procedure for computing the target signal is filtering of the residual signal $r(n)$ through the combination of the synthesis filter 1/A(z) and the weighting filter W(z).

Impulse response $h(n)$ of the weighted synthesis filter W(z)/A(z) is computed for each subframe. In the equation above, A(z) is the quantized LP filter. The impulse response $h(n)$ is needed for the search of adaptive and fixed codebooks. The adaptive codebook search includes performing a closed-loop pitch search, and then computing the adaptive code vector, ep(n), by interpolating the past excitation at a selected fractional pitch lag P. ep(n) can be enhanced, for example, by applying an adaptive low-pass filter. The adaptive codebook parameters (or pitch parameters) are the closed-loop pitch P and the pitch gain 1305, gp (adaptive codebook gain), calculated for each subframe. y(n) notes the filtered adaptive codebook contribution before the pitch gain 1305 is applied. Details about calculating the adaptive codebook parameters will not be discussed here as this section focuses on describing the mixed FCB (fixed codebook) search.

After the filtered and gained adaptive codebook contribution is subtracted from the target signal x(n), the obtained difference signal x2(n) 1304 becomes the second target signal for determining the code-excitation contribution. The code-excitation $e_c$(n) 1308 and the corresponding gain $G_c$ 1306 are determined through the minimization 1309 of the weighted error 1310.

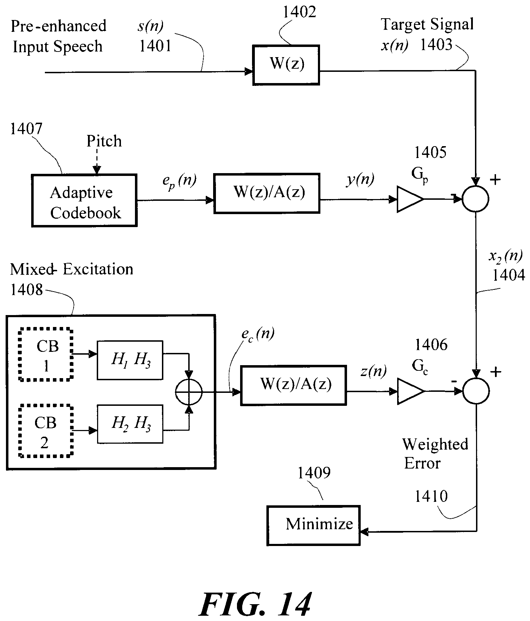

FIG. 14 shows a similar structure as FIG. 13, except the fixed codebook or code-excitation in FIG. 14 is now specifically a mixed codebook structure. The target signal 1403 x(n) for the adaptive codebook 1407 search is computed by subtracting a zero-input response (not shown in FIG.14) of the weighted synthesis filter W(z)/A(z)from the weighted pre-emphasized input signal; and the weighted pre-emphasized input signal is obtained by filtering the input signal s(n) 1401 through the weighting filter 1402. The adaptive codebook parameters (or pitch parameters) are the closed-loop pitch and the pitch gain 1405, gp (adaptive codebook gain), calculated for each subframe. y(n) notes the filtered adaptive codebook contribution before the pitch gain 1405 is applied. After the filtered and gained adaptive codebook contribution is subtracted from the target signal 1403 x(n), the obtained difference signal x2(n)1404 becomes the second target signal for determining the mixed codebook excitation contribution. The mixed codebook excitation 1408 $e_c$(n) and the corresponding gain 1406 $G_c$ are determined through the minimization 1409 of the weighted error 1410. z(n) notes the filtered mixed codebook contribution before the gain 1406 $G_c$ is applied.

Suppose CB 1 in the mixed codebook 1408 is a pulse-like codebook and CB 2 in the mixed codebook 1408 is a noise-like codebook. H1(z) in 1408 notes the enhancement filter for CB 1 vectors, H2(z) in 1408 notes the enhancement filter for CB 2 vectors, and H3(z) in 1408 notes the enhancement filter for both CB1 and CB 2 vectors. For the convenience of the following description, the impulsive response of H1(z), H2(z), or H3(z) is noted as h1(n), h2(n), or h3(n) respectively.

The pulse-like codebook CB 1 index, or code word, represents the pulse positions and signs. Thus, no codebook storage is needed since the code vector can be constructed in the decoder through the information contained in the index itself (no look-up tables). The different pulse-like codebooks can be constructed by placing a certain number of signed pulses in a certain number of tracks. The independent or temporal search of the pulse-like codebook can be performed by first combining the enhancement filters H1(z) and H3(z) with the weighted synthesis filter W(z)/A(z) prior to the codebook search. Thus, the impulse response h(n) of the weighted synthesis filter must be modified to include the enhancement filters H1(z) and H3(z). That is,

$$h_p(n) = h_1(n) * h_3(n) * h(n).$$

$$(9)$$

The noise-like codebook CB 2 index, or code word, represents the noise vectors and signs. The noise-like codebook is normally saved in a memory storage. In order to reduce the memory size, the noise vectors may be overlapped and generated by shifting a noise vector position. The independent or temporal search of the noise-like codebook may be performed by first combining the enhancement filters H2(z) and H3(z) with the weighted synthesis filter W(z)/A(z) prior to the codebook search. Thus, the impulse response h(n) of the weighted synthesis filter must be modified to include the enhancement filters H2(z) and H3(z). That is,

$$h_n(n) = h_2(n) * h_3(n) * h(n).$$

$$(10)$$

As H3(z) is commonly used for both pulse-like vectors and noise-like vectors, the impulse response of the combination of the synthesis filter 1/A(z), the weighting filter W(z) and the enhancement filter H3(z) is specifically noted as,

$$hh(n) = h_3(n) * h(n).$$

$$(11)$$

The mixed codebook is searched by minimizing the error between an updated target signal 1404 x2(n) and a scaled filtered code vector. The updated target signal is given by

$$x_2(n) = x(n) - G_p \cdot y(n) \quad , \quad n = 0,1,........,63$$

$$(12)$$

where y(n) = $e_p$(n)*h(n) is the filtered adaptive code vector and Gp is the adaptive codebook gain. Let a matrix H be defined as a lower triangular Toeplitz convolution matrix with the main diagonal hh(0) and lower diagonals hh(1),...,hh(63), and d=HTx2 (also known as the backward filtered target vector) be the correlation between the updated signal x2(n) and the impulse response hh(n). Furthermore, let Φ = HTH be the matrix of correlations of hh(n). Theoretically, the elements of the vector d(n) may be computed by

$$d(n) \quad = \quad \sum_{i=n}^{63} x_2(i) \cdot hh(i-n) \quad , \quad n = 0,1,..........63,$$

$$(13)$$

and the elements of the symmetric matrix Φ can be computed by

$$\varphi(i,j) \quad = \quad \sum_{n=j}^{63} hh(n-i) \cdot hh(n-j) \quad , \quad i = 0,1,..........63; \quad j = i,...63.$$

$$(14)$$

In some embodiments, equation (13) may be calculated by using a simpler backward filtering, and equation (14) may not be needed in the current case for fast search of the mixed pulse-noise codebook.

Let $c_k(n)$ be a mixed code vector that is

$$c_k(n) = c_p(n) * h_1(n) + c_n(n) * h_2(n) \quad , \quad n = 0,1,\ldots\ldots 63.$$

$$(15)$$

Here, $c_p(n)$ is a candidate vector from the pulse-like codebook and $c_n(n)$ is a candidate vector from the noise-like codebook. The mixed codebook excitation $c_k(n)$ or $e_c(n)=c_k(n)*h_3(n)$ and the corresponding gain 1103 $G_c$ of the mixed codebook excitation may be determined through the minimization 1109 of weighted error 1110:

$$Err = \sum_{n=0}^{63} \left| x_2(n) - G_c \cdot z(n) \right|^2 .$$

$$(16)$$

The minimization of (16) is equivalent to the maximization of the following criterion:

$$Q_k = \frac{(\mathbf{x}_2^T \mathbf{z}_k)^2}{\mathbf{z}_k^T \mathbf{z}_k} = \frac{(\mathbf{x}_2^T \mathbf{H} \mathbf{c}_k)^2}{\mathbf{c}_k^T \mathbf{H}^T \mathbf{H} \mathbf{c}_k} = \frac{(\mathbf{d}^T \mathbf{c}_k)^2}{\mathbf{c}_k^T \mathbf{\Phi} \mathbf{c}_k} = \frac{(R_k)^2}{E_k} .$$

$$(17)$$

In (17), $z_k$ is the filtered contribution of the mixed excitation codebook:

$$\mathbf{z}_k = \mathbf{H} \mathbf{c}_k . \qquad\qquad (18)$$

In some embodiments, vector $d(n)$ and matrix $\Phi$ are computed prior to the codebook search. In some embodiments, the calculation of matrix $\Phi$ may not be needed and, therefore, omitted.

The correlation in the numerator of equation (17) is given by

$$
\begin{aligned}
R_k &= \mathbf{d}^T \mathbf{c}_k \\
&= \mathbf{d}^T (\mathbf{H}_1 \mathbf{c}_p + \mathbf{H}_2 \mathbf{c}_n) \\
&= \mathbf{d}^T \mathbf{H}_1 \mathbf{c}_p + \mathbf{d}^T \mathbf{H}_2 \mathbf{c}_n \\
&= (\mathbf{H}_1^T \mathbf{d})^T \mathbf{c}_p + (\mathbf{H}_2^T \mathbf{d})^T \mathbf{c}_n \\
&= \mathbf{d}_1^T \mathbf{c}_p + \mathbf{d}_2^T \mathbf{c}_n .
\end{aligned}
$$

$$(19)$$

In (19), $\mathbf{d}_1 = \mathbf{H}_1^T \mathbf{d}$ and $\mathbf{d}_2 = \mathbf{H}_2^T \mathbf{d}$ may be pre-calculated by simply backward-filtering $d(n)$ through the filter H1(z) and H2(z). If H1(z) and H2(z) are implemented using first-order filters, the backward-filtering processes are simple. The energy in the denominator of equation (17) is given by

$$
\begin{aligned}
E_k &= \mathbf{c}_k^T \Phi \mathbf{c}_k \\
&= (\mathbf{H}_1 \mathbf{c}_p + \mathbf{H}_2 \mathbf{c}_n)^T \mathbf{H}^T \mathbf{H} (\mathbf{H}_1 \mathbf{c}_p + \mathbf{H}_2 \mathbf{c}_n) \\
&= (\mathbf{H}\mathbf{H}_1 \mathbf{c}_p)^T (\mathbf{H}\,\mathbf{H}_1 \mathbf{c}_p) + 2(\mathbf{H}\mathbf{H}_1 \mathbf{c}_p)^T (\mathbf{H}\mathbf{H}_2 \mathbf{c}_n) + (\mathbf{H}\mathbf{H}_2 \mathbf{c}_n)^T (\mathbf{H}\mathbf{H}_2 \mathbf{c}_n) \\
&= (\mathbf{H}_p \mathbf{c}_p)^T (\mathbf{H}_p \mathbf{c}_p) + 2(\mathbf{H}_p \mathbf{c}_p)^T (\mathbf{H}_n \mathbf{c}_n) + (\mathbf{H}_n \mathbf{c}_n)^T (\mathbf{H}_n \mathbf{c}_n) \\
&= \mathbf{z}_p^T \mathbf{z}_p + 2 \mathbf{z}_p^T \mathbf{z}_n + \mathbf{z}_n^T \mathbf{z}_n .
\end{aligned}
$$

$$(20)$$

In (20), $\mathbf{H}_p = \mathbf{H}\mathbf{H}_1$ and $\mathbf{H}_n = \mathbf{H}\mathbf{H}_2$ may be pre-calculated by the following filtering processes or convolutions:

$$
h_p(n) = h_1(n) * hh(n) \quad \leftrightarrow \quad H_p(z) = H_1(z) H_3(z) W(z) / A(z)
$$

$$(21)$$

$$
h_n(n) = h_2(n) * hh(n) \quad \leftrightarrow \quad H_n(z) = H_2(z) H_3(z) W(z) / A(z) .
$$

$$(22)$$

In some embodiments, H1(z) and H2(z) may be implemented using first-order filters; so, the filtering processing in (21) or (22) is as simple as hh(n) is already calculated in (11).

In (20), $z_p$ is the filtered pulse contribution :

$$
\mathbf{z}_p = \mathbf{H}_p \mathbf{c}_p
$$

$$(23)$$

and $z_n$ is the filtered noise contribution :

$$
\mathbf{z}_n = \mathbf{H}_n \mathbf{c}_n .
$$

$$(24)$$

Equation (20) may be further expressed as,

$$
\begin{aligned}
E_k &= \mathbf{z}_p^T \mathbf{z}_p + 2 \mathbf{z}_p^T \mathbf{z}_n + \mathbf{z}_n^T \mathbf{z}_n \\
&= E_p + 2 \mathbf{z}_p^T \mathbf{z}_n + E_n
\end{aligned}
$$

$$(25)$$

where

$$E_p \;=\; \mathbf{z}_p^T \, \mathbf{z}_p$$

$$(26)$$

is the energy of the filtered pulse contribution and

$$E_n \;=\; \mathbf{z}_n^T \, \mathbf{z}_n$$

$$(27)$$

is the energy of the filtered noise contribution.

Suppose the code vector $c_p(n)$ in (15) from the pulse subcodebook is a signed vector :

$$\mathbf{c}_p \;=\; s_p \cdot \mathbf{v}_p(i_p)$$

$$(28)$$

and the code vector $c_n(n)$ in (15) from the noise subcodebook is also a signed vector :

$$\mathbf{c}_n \;=\; s_n \cdot \mathbf{v}_n(i_n) \, ,$$

$$(29)$$

where $v_p(i_p)$ denotes the $i_p$-the pulse vector of dimension 64 (the subframe size), consisting of one or several pulses; $v_n(i_n)$ denotes the $i_n$-th noise vector of dimension 64 (the subframe size), reading from a noise table; sp and $s_n$ are the signs, equal to -1 or 1, and ip and in are the indices defining the vectors.

The goal of the search procedure is to find the indices ip and in of the two best vectors and their corresponding signs, sp and $s_n$. This is achieved by maximizing the search criterion (17) where the numerator is calculated by using the equation (19) and the denominator is calculated by using the equation (25). Looking at the numerator (19) and the denominator (25), the most complex computation comes from the middle term of the denominator (25), $\mathbf{z}_p^T \mathbf{z}_n$, which contains all the possible combinations of the cross correlations. For example, if cp has $K_p$ possibilities and cn has $K_n$ possibilities, the middle term, $\mathbf{z}_p^T \mathbf{z}_n$, may have up to $(K_p \cdot K_n)$ possibilities.

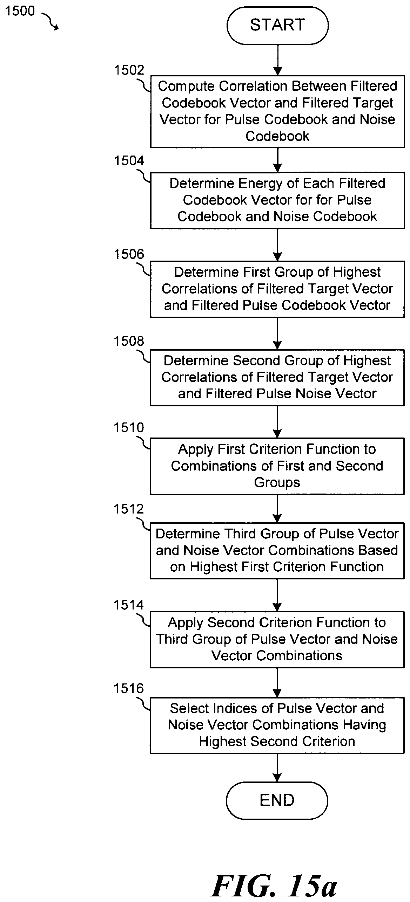

FIG. 15a illustrates flowchart 1500 of an embodiment method of a fast mixed codebook search. In step 1502, a correlation is computed between a codebook vector and each filtered target vector for the pulse codebook and for the noise codebook. In one example, after computing the vectors $\mathbf{d}_1$ and $\mathbf{d}_2$ in (19), a predetermination process is used to identify $K_p^0 \le K_p$ out of all the $K_p$ possible pulse vectors and $K_n^0 \le K_n$ out of all the $K_n$ possible noise vectors so that the search process will be confined to those $K_p^0$ possible pulse vectors and $K_n^0$ possible noise vectors.

The pulse predetermination is performed by testing $R_p(i) = \mathbf{d}_1^T \mathbf{c}_p(i)$ in (19) for the $K_p$ pulse vectors which have the largest absolute dot product (or squared dot product) between d1 and cp. That is the indices of the $K_p^0$ pulse vectors that result in the $K_p^0$ largest values of $|R_p(i)|$ are retained. These indices are stored in the index vector mi, i=0,...,

$K_p^0 - 1$. To further simplify the search, the sign information corresponding to each predetermined vector is also preset. The sign corresponding to each predetermined vector is given by the sign of $R_p(i)$ for that vector. These preset signs are stored in the sign vector $s_p(i)$, i=0,..., $K_p^0 - 1$. As the candidate vectors cp contain many zeros, the above predetermination may be computationally simple in some embodiments.

The noise predetermination is performed by testing $R_n(j) = \mathbf{d}_2^T \mathbf{c}_n(j)$ in (19) for the $K_n$ noise vectors which have the largest absolute dot product (or squared dot product) between d2 and cn . That is the indices of the $K_n^0$ noise vectors that result in the $K_n^0$ largest values of $|R_n(j)|$ are retained. These indices are stored in the index vector nj, j=0,..., $K_n^0 - 1$. To further simplify the search, the sign information corresponding to each predetermined vector is also preset. The sign corresponding to each predetermined vector is given by the sign of $R_p(j)$ for that vector. These preset signs are stored in the sign vector $s_n(j)$, j= 0,..., $K_n^0 - 1$.

Since the mixed excitation codebook is often used for low bit rates speech coding, $K_p$ or $K_n$ is not large; in this case, the predetermination process simply takes all the $K_p^0 = K_p$ possible pulse vectors as candidates and all the $K_n^0 = K_n$ possible noise vectors as candidates.

In step 1504, the energy of each filtered codebook vector is determined for the pulse codebook and for the noise codebook. For example, energy term $E_p(i) = \mathbf{z}_p^T \mathbf{z}_p$ of the filtered pulse vectors in equation (25) is computed for the limited $K_p^0$ possible pulse vectors from Step 1502, and stored with the index vector mi, i=0,..., $K_p^0 - 1$. In some embodiments, the pulse vectors contain only few non-zero pulses, thereby making the computation of zp in equation (23) relatively simple. For example, if the pulse vectors contain only one pulse, this computation of the energy term may be simply done by using a recursive way and shifting the pulse position from left to right.

Energy term $E_n(j) = \mathbf{z}_n^T \mathbf{z}_n$ of the filtered noise vectors in (25) is computed for the limited $K_n^0$ possible noise vectors from Step 1502, and stored with the index vector nj, j= 0,..., $K_n^0 - 1$. If all of the noise vectors are stored in a table in an overlapped manner, the computation of $z_n$ in equation (24) may be done in a recursive way and shifting the noise vector position in the noise table.

Next, in step 1506, a first group of highest correlations of filtered target vectors and filtered pulse codebook vectors are computed, and in step 1508, a second group of highest correlations of filtered target vectors and filtered pulse noise vectors are computed. For example, in one embodiment, K possible combinations of the mixed pulse-noise contributions are from the $(K_p^0 \cdot K_n^0)$ possible combinations that are obtained from step 1502 and step 1504 are computed and chosen. In one embodiment, K is much smaller than $(K_p^0 \cdot K_n^0)$, that is $K < (K_p^0 \cdot K_n^0)$. In some example, four noise vectors and six pulse vectors are chosen to be the K possible combinations, thereby making a total of 24 combinations to be tested. In other examples, other numbers of noise vectors and pulse vectors may be selected. In an embodiment, the number of candidate pulse vectors may exceed the number of candidate noise vectors since calculations on pulse vectors may be more computationally efficient than performing calculations of noise vectors due to the sparse nature of some pulse vectors. (I.e., many of the elements within the pulse vectors may be set to zero.)

Next, a first criterion function is applied to these combinations of the first and second groups in step 1510. In one embodiment, the selection of the K possible combinations may be achieved by maximizing the following simplified criterion of (17),

$$Q(i,j) = \frac{[\,R_p(i) + R_n(j)\,]^2}{E_p(i) + E_n(j)} \quad ; \quad i = 0,1,...,K_p^0 - 1 \quad ; \quad j = 0,1,...,K_n^0 - 1$$

(30)

$$MAX \{ \; Q(i,j) \; , \quad i = 0,1,...,K_p^0 - 1 \quad ; \quad j = 0,1,...,K_n^0 - 1 \; \}.$$

(31)

In the above expression, $R_p(i)$ and $R_n(j)$ have been computed in step 1502; Ep(i) and $E_n(j)$ have been computed in step 1504.

Next, in step 1512, a first group of pulse vector and noise vector combinations are determined based on the highest first criterion functions. For example, in one embodiment, the indices of the K combinations that result in the K largest values of $Q(i,j)$ are retained. These indices are stored in the index matrix $[i_k, j_k]$, $k = 0,1,...,K$-1. K is much smaller than the number of the total possible combinations of the pulse and noise vectors.

Next, a second criterion function is applied to the third group of pulse vector and noise vector combinations in step 1514, and the indices of the pulse vector and noise vector hacing the highest second criterion is selected. For example, in one embodiment, once the most promising K combinations of the pulse and noise vectors and their corresponding signs are predetermined in the above Step 1502, 1504, 1506, 1508, 1510, and 1512, the search proceeds with the selection of one pulse vector and one noise vector among those K combinations, which will maximize the full search criterion $Q_k$ of (17) :

$$Q_k \;=\; \frac{(R_k)^2}{E_k} \;=\; \frac{[\,R_p(i_k) + R_n(j_k)]^2}{E_p(i_k) + 2\,\mathbf{z}_p(i_k)^T \mathbf{z}_n(j_k) + E_n(j_k)} \quad , \quad k = 0,1,...,K-1.$$

(32)

$$MAX \; \{ \; Q_k \; , \quad k = 0,1,...,K-1 \; \}.$$

(33)

In (32), $R_p(i_k)$, $R_n(j_k)$, $E_p(i_k)$ and $E_n(j_k)$ have been obtained in steps 1502 and 1504, $z_p(i_k)$ and $z_n(j_k)$ have been computed in step 1504. In case that the pulse vectors contain only one pulse, the filtered pulse vector $z_p(i_k)$ in (32) could have zeros from the first element of the vector to the pulse position, which can further simplify the computation.

In some embodiments of the present invention, steps 1510 and 1512 may be omitted in embodiments have a relatively small number of codebook entries. In such an embodiment, the candidate combinations of the first and second groups are applied directly to the second criterion function, for example, equations (32) and (33), and the indices corresponding to the maximum value of the second criterion function are selected.

If there is no limitation that CB 1 contains pulse vectors and CB 2 contains noise vectors, the general mixed codebook can be fast-searched in the following way similar to the above description regarding a codebook using pulse and noise vectors. The impulse response for the CB 1 excitation is ,

$$h_{CB1}(n) = h_1(n) * h_3(n) * h(n).$$

(34)

The impulse response for the CB 2 excitation is,

$$h_{CB2}(n) = h_2(n) * h_3(n) * h(n)$$

$$(35)$$

Let $c_k(n)$ be a mixed code vector which is

$$c_k(n) = c_{CB1}(n) * h_1(n) + c_{CB2}(n) * h_2(n) \quad , \quad n = 0,1,\ldots\ldots63.$$

$$(36)$$

The mixed codebook excitation $c_k(n)$ or $e_c(n)=c_k(n)*h_3(n)$ and the corresponding gain 1406 $G_c$ may be determined through the minimization of the criterion:

$$Q_k = \frac{(R_k)^2}{E_k} = \frac{[\,\mathbf{d}_1^T \mathbf{c}_{CB1} + \mathbf{d}_2^T \mathbf{c}_{CB2}\,]^2}{E_{CB1} + 2\,\mathbf{z}_{CB1}^T \mathbf{z}_{CB2} + E_{CB2}}$$

$$(37)$$

where

$$\mathbf{z}_{CB1} = \mathbf{H}_{CB1}\mathbf{c}_{CB1}$$

$$(38)$$

$$\mathbf{z}_{CB2} = \mathbf{H}_{CB2}\mathbf{c}_{CB2}$$

$$(39)$$

$$E_{CB1} = \mathbf{z}_{CB1}^T \mathbf{z}_{CB1}$$

$$(40)$$

$$E_{CB2} = \mathbf{z}_{CB2}^T \mathbf{z}_{CB2}.$$

$$(41)$$

Suppose the code vectors $\mathbf{c}_{CB1}$ and $\mathbf{c}_{CB2}$ are signed vectors :

$$\mathbf{c}_{CB1} = s_{CB1} \cdot \mathbf{v}_{CB1}(i_{CB1})$$

$$(42)$$

$$\mathbf{c}_{CB2} = s_{CB2} \cdot \mathbf{v}_{CB2}(i_{CB2})_{\,.}$$

$$(43)$$

The goal of the search procedure is to find the indices $i_{CB1}$ and $i_{CB2}$ of the two best vectors and their corresponding signs, $s_{CB1}$ and $s_{CB2}$.

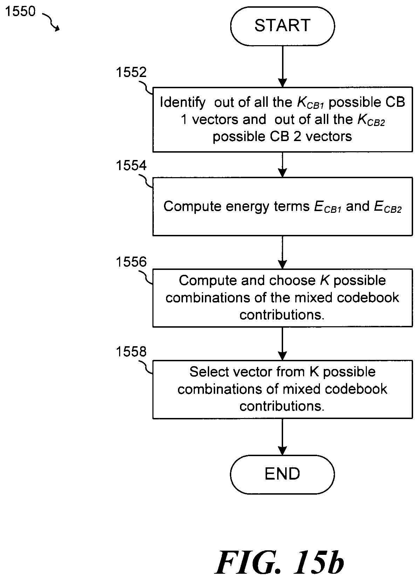

FIG. 15b illustrates embodiment method 1550 for performing a fast search of a general mixed codebook. It should be appreciated that method 1500 of Figure 15a described above maybe considered a special case of method 1550 in some embodiments.

In an embodiment, in step 1552, after computing the vectors $\mathbf{d}_1$ and $\mathbf{d}_2$ in (37), a predetermination process is used to identify $K_{CB1}^0 \leq K_{CB1}$ out of all the $K_{CB1}$ possible CB 1 vectors and $K_{CB2}^0 \leq K_{CB2}$ out of all the $K_{CB2}$ possible CB 2 vectors. The CB 1 predetermination is performed by testing $R_{CB1}(i) = \mathbf{d}_1^T \mathbf{c}_{CB1}(i)$ in equation (37) for the $K_{CB1}$ CB 1 vectors which have the largest absolute dot product (or squared dot product) between d1 and $c_{CB1}$. That is, the indices of the $K_{CB1}^0$ CB 1 vectors that result in the $K_{CB1}^0$ largest values of $|R_{CB1}(i)|$ are retained. These indices are stored in the index vector mi, i = 0,..., $K_{CB1}^0 - 1_{\,.}$ To further simplify the search, the sign information corresponding to each predetermined vector is also preset. The sign corresponding to each predetermined vector is given by the sign of $R_{CB1}(i)$ for that vector. These preset signs are stored in the sign vector $s_{CB1}(i)$, i = 0,..., $K_{CB1}^0 - 1_{\,.}$

In an embodiment, the CB 2 predetermination is performed by testing $R_{CB2}(j) = \mathbf{d}_2^T \mathbf{c}_{CB2}(j)$ in equation (37) for the $K_{CB2}$ CB 2 vectors which have the largest absolute dot product (or squared dot product) between d2 and $c_{CB2}$. That is, the indices of the $K_{CB2}^0$ CB 2 vectors that result in the $K_{CB2}^0$ largest values of $|R_{CB2}(j)|$ are retained. These indices are stored in the index vector nj, j=0,..., $K_{CB2}^0 - 1_{\,.}$ To further simplify the search, the sign information corresponding to each predetermined vector is also preset. The sign corresponding to each predetermined vector is given by the sign of $R_{CB2}(j)$ for that vector. These preset signs are stored in the sign vector $s_{CB2}(j)$, j=0,..., $K_{CB2}^0 - 1_{\,.}$

As the mixed excitation codebook is often used for low bit rates speech coding, $K_{CB1}$ or $K_{CB2}$ is not large. In this case, the predetermination process simply takes all the $K_{CB1}^0 = K_{CB1}$ possible CB 1 vectors as candidates and all the $K_{CB2}^0 = K_{CB2}$ possible CB 2 vectors as candidates.

Next, in step 1554, energy terms $E_{CB1}$ and $E_{CB2}$ are computed. In an embodiment, term $E_{CB1}(i) = \mathbf{z}_{CB1}^T \mathbf{z}_{CB1}$ of the filtered CB 1 vectors in equation (40) is computed for the limited $K_{CB1}^0$ possible CB 1 vectors from Step 1552, stored with the index vector mi, i=0,..., $K_{CB1}^0 - 1_{\,.}$

Energy term $E_{CB2}(j) = \mathbf{z}_{CB2}^T \mathbf{z}_{CB2}$ of the filtered CB 2 vectors in equation (41) is also computed for the limited $K_{CB2}^0$ possible CB 2 vectors from Step 1552, stored with the index vector, nj, j=0,..., $K_{CB2}^0 - 1_{\,.}$ In some embodiments, energy terms $E_{CB1}$ and $E_{CB2}$ may be pre-computed and stored in memory.

In step 1556, Compute and choose K possible combinations of the mixed codebook contributions from the $(K_{CB1}^0 \cdot K_{CB2}^0)$ possible combinations obtained by step 1552 and step 1554 are computed and chosen. In some embodiments, K is smaller than $(K_{CB1}^0 \cdot K_{CB2}^0)$, that is $K < (K_{CB1}^0 \cdot K_{CB2}^0)_{\,.}$ The selection of the K possible combinations is achieved by maximizing the following simplified criterion of (37),

$$Q(i,j) = \frac{[\,R_{CB1}(i) + R_{CB2}(j)\,]^2}{E_{CB1}(i) + E_{CB2}(j)} \quad ; \quad i = 0,1,...,K^0_{CB1} - 1 \quad ; \quad j = 0,1,...,K^0_{CB2} - 1$$

(44)

$$MAX\;\{\;Q(i,j)\;,\quad i = 0,1,...,K^0_{CB1} - 1 \quad ; \quad j = 0,1,...,K^0_{CB2} - 1\;\}$$

(45)

In the above expression, $R_{CB1}(i)$ and $R_{CB2}(j)$ have been computed in Step 1552, and $E_{CB1}(i)$ and $E_{CB2}(j)$ have been computed in Step 1554. The indices of the K combinations that result in the K largest values of $Q(i,j)$ are retained. These indices are stored in the index matrix $[i_k, j_k]$, $k = 0,1,...,K-1$. K is much smaller than the number of the total possible combinations of the mixed codebook vectors.

Next in step 1558, a vector is selected from the K possible combinations determined in step 1556. For example, once the most promising K combinations of the mixed codebook vectors and their corresponding signs are predetermined in the above Step 1552, Step 1554 and Step 1556, the search proceeds with the selection of one CB 1 vector and one CB 2 vector among those K combinations, which will maximize the full search criterion $Q_k$ of (3 7) :

$$Q_k \;=\; \frac{[\,R_{CB1}(i_k) + R_{CB2}(j_k)\,]^2}{E_{CB1}(i_k) + 2\,\mathbf{z}_{CB1}(i_k)^T \mathbf{z}_{CB2}(j_k) + E_{CB2}(j_k)} \;,\quad k = 0,1,...,K-1.$$

(46)

$$MAX\;\{\;Q_k\;,\quad k = 0,1,...,K-1\;\}$$

(47)

In (46), $R_{CB1}(i_k)$, $R_{CB2}(j_k)$, $E_{CB1}(i_k)$ and $E_{CB2}(j_k)$ have been obtained in Step 1556; $z_{CB1}(i_k)$ and $z_{CB2}(j_k)$ have been computed in Step 1554.

In some embodiments of the present invention, the computation of equations (44) and (45) may be omitted and equations (46) and (47) may be used to determine the selected mixed codebook vector directly for embodiments having a relatively small size codebook.

Steps 1510 and 1512 may be omitted in embodiments having a relatively small number of codebook entries. In such an embodiment, the candidate combinations of the first and second groups are applied directly to the second criterion function, for example, equations (32) and (33), and the indices corresponding to the maximum value of the second criterion function are selected and evaluated as follows:

$$Q(i,j) \;=\; \frac{[\,R_{CB1}(i) + R_{CB2}(j)\,]^2}{E_{CB1}(i) + 2\,\mathbf{z}_{CB1}(i)^T \mathbf{z}_{CB2}(j) + E_{CB2}(j)}$$

$$i = 0,1,...,K^0_{CB1} - 1 \quad ; \quad j = 0,1,...,K^0_{CB2} - 1$$

(48)

$$MAX\ \{\ Q(i,j)\ ,\quad i = 0,1,...,K^0_{CB1} - 1\quad;\quad j = 0,1,...,K^0_{CB2} - 1\quad\}$$

$$(49)$$

Equations (48) and (49) may also be applied to method 1500 discussed above in some embodiments.

Signal to Noise Ratio (SNR) is one of the objective test measuring methods for speech coding. Weighted Segmental SNR (WsegSNR) is another objective measuring. WsegSNR might be slightly closer to real perceptual quality measuring than SNR. Small difference in SNR or WsegSNR may not be audible. Large difference in SNR or WsegSNR may obviously be audible. For clean speech signal, the obtained SNR or WsegSNR with the pulse-noise mixed FCB may be equivalent to the ones obtained by using a pulse-like FCB with the same FCB size. For noisy speech signal, the obtained SNR or WsegSNR with the pulse-noise mixed FCB may be slightly higher than the ones obtained by using a pulse-like FCB with the same FCB size. Furthermore, for all kind of speech signals, the obtained SNR or WsegSNR with the fast mixed FCB search is very close to the ones with the full mixed FCB search.

In some embodiments, listening test results indicate that the perceptual quality of noisy speech signal is clearly improved by using the pulse-noise mixed FCB instead of a pulse-like FCB, which sounds smoother, more natural and less spiky. In addition, test results show that the perceptual quality with the fast mixed FCB search is equivalent to the one with the full mixed FCB search.

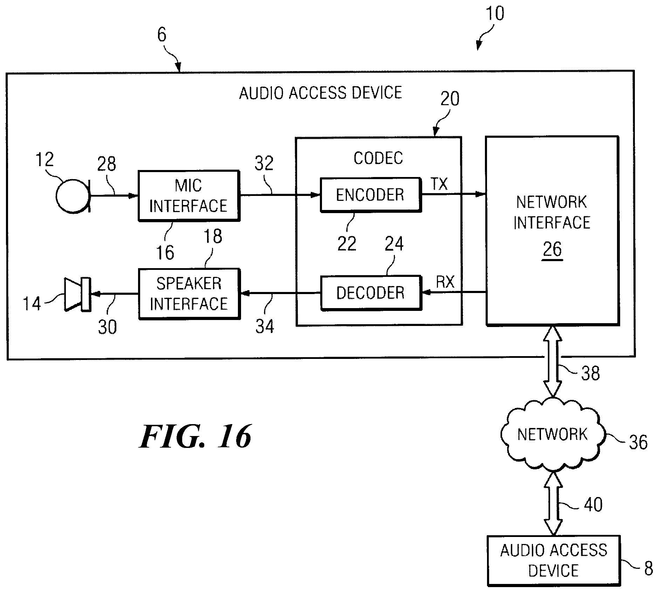

FIG. 16 illustrates communication system 10 according to an embodiment of the present invention. Communication system 10 has audio access devices 6 and 8 coupled to network 36 via communication links 38 and 40. In one embodiment, audio access device 6 and 8 are voice over internet protocol (VOIP) devices and network 36 is a wide area network (WAN), public switched telephone network (PTSN) and/or the internet. Communication links 38 and 40 are wireline and/or wireless broadband connections. In an alternative embodiment, audio access devices 6 and 8 are cellular or mobile telephones, links 38 and 40 are wireless mobile telephone channels and network 36 represents a mobile telephone network.

Audio access device 6 uses microphone 12 to convert sound, such as music or a person's voice into analog audio input signal 28. Microphone interface 16 converts analog audio input signal 28 into digital audio signal 32 for input into encoder 22 of CODEC 20. Encoder 22 produces encoded audio signal TX for transmission to network 26 via network interface 26 according to embodiments of the present invention. Decoder 24 within CODEC 20 receives encoded audio signal RX from network 36 via network interface 26, and converts encoded audio signal RX into digital audio signal 34. Speaker interface 18 converts digital audio signal 34 into audio signal 30 suitable for driving loudspeaker 14.

In embodiments of the present invention, where audio access device 6 is a VOIP device, some or all of the components within audio access device 6 are implemented within a handset. In some embodiments, however, Microphone 12 and loudspeaker 14 are separate units, and microphone interface 16, speaker interface 18, CODEC 20 and network interface 26 are implemented within a personal computer. CODEC 20 can be implemented in either software running on a computer or a dedicated processor, or by dedicated hardware, for example, on an application specific integrated circuit (ASIC). Microphone interface 16 is implemented by an analog-to-digital (A/D) converter, as well as other interface circuitry located within the handset and/or within the computer. Likewise, speaker interface 18 is implemented by a digital-to-analog converter and other interface circuitry located within the handset and/or within the computer. In further embodiments, audio access device 6 can be implemented and partitioned in other ways known in the art.

In embodiments of the present invention where audio access device 6 is a cellular or mobile telephone, the elements within audio access device 6 are implemented within a cellular handset. CODEC 20 is implemented by software running on a processor within the handset or by dedicated hardware. In further embodiments of the present invention, audio access device may be implemented in other devices such as peer-to-peer wireline and wireless digital communication systems, such as intercoms, and radio handsets. In applications such as consumer audio devices, audio access device may contain a CODEC with only encoder 22 or decoder 24, for example, in a digital microphone system or music playback device. In other embodiments of the present invention, CODEC 20 can be used without microphone 12 and speaker 14, for example, in cellular base stations that access the PTSN.

In accordance with an embodiment, a method of encoding an audio/speech signal includes determining a mixed codebook vector based on an incoming audio/speech signal, the mixed codebook vector comprising a sum of a first codebook entry from a first codebook and a second codebook entry from a second codebook. The method further includes generating an encoded audio signal based on the determined mixed codebook vector, and transmitting a coded excitation index of the determined mixed codebook vector. In an embodiment, the first codebook includes pulse-like entries and the second codebook includes noise-like entries. In some embodiments, the first and second codebooks include fixed codebooks. The steps of determining and generating may be performed using a hardware-based audio encoder. The hardware-based audio encoder may include a processor and/or dedicated hardware.

In an embodiment, determining the mixed codebook vector includes computing first correlations between a filtered target vector and filtered entries in the first codebook, determining a first group of highest first correlations, computing correlations between a filtered target vector and filtered entries in the second codebook, determining a second group of highest second correlations, and computing a first criterion function of combinations of the first and second groups. The first criterion function includes a function of one of the first group of highest first correlations, one of the second group of highest second correlations and an energy of corresponding entries from the first codebook and the second codebook. The filtered target vector is based on the incoming audio signal.

In an embodiment the method further includes determining a third group of candidate correlations based on highest computed first criterion functions, and selecting the mixed codebook vector based on applying a second criterion function to the third group. The mixed codebook vector corresponds to codebook entries from the first codebook and the second codebook associated with a highest value of the second criterion function.

In an embodiment, the first criterion function is

$$Q(i,j) = \frac{[\,R_{CB1}(i) + R_{CB2}(j)\,]^2}{E_{CB1}(i) + E_{CB2}(j)} \quad ; \quad i = 0,1,...,K^0_{CB1} - 1 \quad ; \quad j = 0,1,...,K^0_{CB2} - 1$$
,

where $R_{CB1}(i)$ is a correlation between the filtered target vector and an $i^{th}$ first entry of the first codebook, $R_{CB2}(j)$ is a correlation between the filtered target vector and a $j^{th}$ entry of the second codebook, $E_{CB1}(i)$ is an energy of the $i^{th}$ entry of the first codebook and $E_{CB2}(i)$ is an energy of the $j^{th}$ entry of the second codebook, $K^0_{CB1}$ is a number of first codebook entries in the first group and $K^0_{CB2}$ is a number of second codebook entries in the second group. The second criterion may be expressed as

$$Q_k = \frac{[\,R_{CB1}(i_k) + R_{CB2}(j_k)]^2}{E_{CB1}(i_k) + 2\,\mathbf{z}_{CB1}(i_k)^T\,\mathbf{z}_{CB2}(j_k) + E_{CB2}(j_k)} \quad , \quad k = 0,1,...,K-1$$
,

where $\mathbf{z}_{CB1}(i_k)$ is a filtered vector of the $i^{th}$ entry of the first codebook and $\mathbf{z}_{CB2}(j_k)$ is a filtered vector of the $j^{th}$ entry of the second codebook, and K is a number of entries in the third group.

In some embodiments, the method includes selecting the mixed codebook vector based on a highest computed first criterion function. This highest computed first criterion function may be

$$Q(i,j) = \frac{[\,R_{CB1}(i) + R_{CB2}(j)\,]^2}{E_{CB1}(i) + E_{CB2}(j)} \quad ; \quad i = 0,1,...,K^0_{CB1} - 1 \quad ; \quad j = 0,1,...,K^0_{CB2} - 1$$

where $R_{CB1}(i)$ is a correlation between the filtered target vector and an $i^{th}$ first entry of the first codebook, $R_{CB2}(j)$ is a correlation between the filtered target vector and a $j^{th}$ entry of the second codebook, $E_{CB1}(i)$ is an energy of the $i^{th}$ entry of the first codebook and $E_{CB2}(i)$ is an energy of the $j^{th}$ entry of the second codebook, and $K^0_{CB1}$ is a number of first codebook entries in the first group and $K^0_{CB2}$ is a number of second codebook entries in the second group.

In an embodiment, the method further includes comprising calculating energies of the corresponding entries from the first codebook and the second codebook. In some cases, the energy of corresponding entries from the first codebook and the second codebook are stored in memory. Furthermore, first group may include more entries than the second group.

In an embodiment, the method further includes applying a first emphasis function to the first codebook entry, and applying a second emphasis function to the second codebook entry. The first emphasis function may include a low pass filtering function, and the second emphasis function may include a high pass filtering function.

In accordance with a further embodiment, a system for encoding an audio/speech signal that includes a hardware-based audio coder configured to determine a mixed codebook vector based on an incoming audio/speech signal, generate an encoded audio/speech signal based on the determined mixed codebook vector, transmit a coded excitation index of the determined mixed codebook vector. The mixed codebook vector includes a sum of a first codebook entry from a pulse-like codebook and a second codebook entry from a noise-like codebook. The hardware-based audio encoder may include a processor and/or dedicated hardware.

In an embodiment, the hardware-based audio coder is further configured to compute first correlations between a filtered target vector and entries in the pulse-like codebook, determine a first group of highest first correlations, compute correlations between a filtered target vector and entries in the noise-like codebook, determine a second group of highest second correlations, and compute a first criterion function of combinations of first and second groups. The first criterion function includes a function of one of the first group of highest first correlations, one of the second group of highest second correlations and an energy of corresponding entries from the pulse-like codebook and the noise-like codebook. Furthermore, the filtered target vector is based on the incoming audio signal. In some embodiments, the system further includes a memory configured to store values of the energy of corresponding entries from the pulse-like codebook and the noise-like codebook.

In an embodiment, the hardware-based audio coder may be further configured to select the mixed codebook vector based on a highest computed first criterion function. This first criterion function may be expressed as

$$Q(i,j) = \frac{[\,R_{CB1}(i) + R_{CB2}(j)\,]^2}{E_{CB1}(i) + E_{CB2}(j)} \quad ; \quad i = 0,1,...,K_{CB1}^0 - 1 \quad ; \quad j = 0,1,...,K_{CB2}^0 - 1$$

where $R_{CB1}(i)$ is a correlation between the filtered target vector and an $i^{th}$ first entry of the first codebook, $R_{CB2}(j)$ is a correlation between the filtered target vector and a $j^{th}$ entry of the second codebook, $E_{CB1}(i)$ is an energy of the $i^{th}$ entry of the first codebook and $E_{CB2}(i)$ is an energy of the $j^{th}$ entry of the second codebook, and $K_{CB1}^0$ is a number of first codebook entries in the first group and $K_{CB2}^0$ is a number of second codebook entries in the second group.

In accordance with a further embodiment, a fast search method of a mixed codebook for encoding an audio/speech signal includes determining a mixed codebook vector based on an incoming audio/speech signal, where the mixed codebook vector includes a sum of a first codebook entry from a first codebook and a second codebook entry from a second codebook. The method further includes computing first correlations between a filtered target vector and filtered entries in the first codebook determining a first group of highest first correlations, computing correlations between a filtered target vector and filtered entries in the second codebook, determining a second group of highest second correlations, and computing a first criterion function of combinations of the first and second groups. The first criterion function includes a function of one of the first group of highest first correlations, one of the second group of highest second correlations and an energy of corresponding entries from the first codebook and the second codebook, and the filtered target vector is based on the incoming audio signal. The method further includes determining a third group of candidate correlations based on highest computed first criterion functions, selecting the mixed codebook vector based on applying a second criterion function to the third group, wherein the mixed codebook vector corresponds to codebook entries from the first codebook and the second codebook associated with a highest value of the second criterion function. In addition, the method further includes generating an encoded audio signal based on the determined mixed codebook vector, and transmitting a coded excitation index of the determined mixed codebook vector, wherein the determining and generating are performed using a hardware-based audio encoder. The hardware-based audio encoder may include a processor and/or dedicated hardware.

In an embodiment, the first criterion function is

$$Q(i,j) = \frac{[\,R_{CB1}(i) + R_{CB2}(j)\,]^2}{E_{CB1}(i) + E_{CB2}(j)} \quad ; \quad i = 0,1,...,K_{CB1}^0 - 1 \quad ; \quad j = 0,1,...,K_{CB2}^0 - 1,$$

where $R_{CB1}(i)$ is a correlation between the filtered target vector and an $i^{th}$ first entry of the first codebook, $R_{CB2}(j)$ is a correlation between the filtered target vector and a $j^{th}$ entry of the second codebook, $E_{CB1}(i)$ is an energy of the $i^{th}$ entry of the first codebook and $E_{CB2}(i)$ is an energy of the $j^{th}$ entry of the second codebook, $K_{CB1}^0$ is a number of first codebook entries in the first group and $K_{CB2}^0$ is a number of second codebook entries in the second group. The

$$Q_k \;=\; \frac{[R_{CB1}(i_k)+R_{CB2}(j_k)]^2}{E_{CB1}(i_k)+2\,\mathbf{z}_{CB1}(i_k)^T\,\mathbf{z}_{CB2}(j_k)+E_{CB2}(j_k)} \quad,\quad k=0,1,...,K-1,$$

where $z_{CB1}(i_k)$ is a filtered vector of the $i^{th}$ entry of the first codebook and $\mathbf{z}_{CB2}(j_k)$ is a filtered vector of the $j^{th}$ entry of the second codebook, and $K$ is a number of entries in the third group. In some embodiments, the first codebook may be a pulse-like codebook and the second codebook may be a noise-like codebook.

An advantage of embodiment systems that use mixed pulse-noise excitation include the ability to produce a better perceptual quality of GENERIC speech signal than using pulse only excitation or noise only excitation. Furthermore, in some embodiments, a fast search approach of the pulse-noise excitation results in a low complexity system, thereby making the pulse-noise excitation algorithm more attractive.

While this invention has been described with reference to illustrative embodiments, this description is not intended to be construed in a limiting sense.

**Claims**

1. A method of CELP encoding an audio/speech signal, the method comprising:

    determining a mixed codebook vector based on an incoming audio/speech signal, the mixed codebook vector comprising a sum of a first codebook entry from a first codebook and a second codebook entry from a second codebook, wherein the first codebook comprises pulse-like entries and the second codebook comprises noise-like entries;
    generating an encoded audio signal based on the determined mixed codebook vector; and
    transmitting a coded excitation index of the determined mixed codebook vector, wherein the determining and generating are performed using a hardware-based audio encoder;
    wherein the first and second codebooks are fixed codebooks.

2. The method of claim 1, wherein determining the mixed codebook vector comprises:

    computing first correlations between a filtered target vector and filtered entries in the first codebook, wherein the filtered target vector is based on the incoming audio signal;
    determining a first group of highest first correlations;
    computing correlations between a filtered target vector and filtered entries in the second codebook;
    determining a second group of highest second correlations; and
    computing a first criterion function of combinations of the first and second groups, wherein the first criterion function comprises a function of one of the first group of highest first correlations, one of the second group of highest second correlations and an energy of corresponding entries from the first codebook and the second codebook.

3. The method of claim 2, further comprising:

    determining a third group of candidate correlations based on highest computed first criterion functions; and
    selecting the mixed codebook vector based on applying a second criterion function to the third group, wherein the mixed codebook vector corresponds to codebook entries from the first codebook and the second codebook associated with a highest value of the second criterion function.

4. The method of claim 3, wherein:

    the first criterion function is

$$Q(i,j) = \frac{[R_{CB1}(i)+R_{CB2}(j)]^2}{E_{CB1}(i)+E_{CB2}(j)} \;\;;\;\; i=0,1,...,K^0_{CB1}-1 \;\;;\;\; j=0,1,...,K^0_{CB2}-1$$

,

where $R_{CB1}(i)$ is a correlation between the filtered target vector and an $i^{th}$ first entry of the first codebook, $R_{CB2}(j)$ is a correlation between the filtered target vector and a $j^{th}$ entry of the second codebook, $E_{CB1}(i)$ is an energy of the $i^{th}$ entry of the first codebook and $E_{CB2}(i)$ is an energy of the $j^{th}$ entry of the second codebook, $K_{CB1}^0$ is a number of first codebook entries in the first group and $K_{CB2}^0$ is a number of second codebook entries in the second group; and

the second criterion function is

$$Q_k = \frac{[\,R_{CB1}(i_k) + R_{CB2}(j_k)\,]^2}{E_{CB1}(i_k) + 2\,\mathbf{z}_{CB1}(i_k)^T\,\mathbf{z}_{CB2}(j_k) + E_{CB2}(j_k)} \quad, \quad k = 0, 1, ..., K-1 \quad ,$$

where $\mathbf{z}_{CB1}(i_k)$ is a filtered vector of the $i^{th}$ entry of the first codebook and $\mathbf{z}_{CB2}(j_k)$ is a filtered vector of the $j^{th}$ entry of the second codebook, and K is a number of entries in the third group.

5. The method of claim 4, wherein selecting the mixed codebook vector based on a highest computed first criterion function.

6. The method of claim 5, wherein the first criterion function is

$$Q(i,j) = \frac{[\,R_{CB1}(i) + R_{CB2}(j)\,]^2}{E_{CB1}(i) + E_{CB2}(j)} \quad ; \quad i = 0, 1, ..., K_{CB1}^0 - 1 \quad ; \quad j = 0, 1, ..., K_{CB2}^0 - 1$$

where $R_{CB1}(i)$ is a correlation between the filtered target vector and an $i^{th}$ first entry of the first codebook, $R_{CB2}(j)$ is a correlation between the filtered target vector and a $j^{th}$ entry of the second codebook, $E_{CB1}(i)$ is an energy of the $i^{th}$ entry of the first codebook and $E_{CB2}(i)$ is an energy of the $j^{th}$ entry of the second codebook, and $K_{CB1}^0$ is a number of first codebook entries in the first group and $K_{CB2}^0$ is a number of second codebook entries in the second group.

7. The method of claim 2, further comprising calculating energies of the corresponding entries from the first codebook and the second codebook.

8. The method of claim 2, wherein the energy of corresponding entries from the first codebook and the second codebook are stored in memory.

9. The method of claim 2, wherein the first group comprises more entries than the second group.

10. The method of claim 1, further comprising:

    applying a first emphasis function to the first codebook entry; and
    applying a second emphasis function to the second codebook entry.

11. The method of claim 10, wherein:

    the first emphasis function comprises a low pass filtering function; and
    the second emphasis function comprises a high pass filtering function.

12. The method of claim 1, wherein the hardware-based audio encoder comprises a processor.

13. The method of claim 1, wherein the hardware-based audio encoder comprises dedicated hardware.

14. A system for CELP encoding an audio/speech signal, the system comprising:

a hardware-based audio coder configured to:

> determine a mixed codebook vector based on an incoming audio/speech signal, the mixed codebook vector comprising a sum of a first codebook entry from a pulse-like codebook and a second codebook entry from a noise-like codebook, wherein the first and second codebooks are fixed codebooks;
> generate an encoded audio/speech signal based on the determined mixed codebook vector; and
> transmit a coded excitation index of the determined mixed codebook vector.

15. The system of claim 14, wherein the hardware-based audio coder is further configured to:

> compute first correlations between a filtered target vector and entries in the pulse-like codebook, wherein the filtered target vector is based on the incoming audio signal;
> determine a first group of highest first correlations;
> compute correlations between a filtered target vector and entries in the noise-like codebook;
> determine a second group of highest second correlations; and
> compute a first criterion function of combinations of first and second groups,
> wherein the first criterion function comprises a function of one of the first group of highest first correlations, one of the second group of highest second correlations and an energy of corresponding entries from the pulse-like codebook and the noise-like codebook.

16. The system of claim 15, further comprising a memory configured to store values of the energy of corresponding entries from the pulse-like codebook and the noise-like codebook.

17. The system of claim 15, wherein the hardware-based audio coder is further configured to select the mixed codebook vector based on a highest computed first criterion function.

18. The system of claim 15, wherein the first criterion function is

$$Q(i,j) = \frac{[\,R_{CB1}(i) + R_{CB2}(j)\,]^2}{E_{CB1}(i) + E_{CB2}(j)} \quad ; \quad i = 0,1,...,K_{CB1}^0 - 1 \quad ; \quad j = 0,1,...,K_{CB2}^0 - 1$$

where $R_{CB1}(i)$ is a correlation between the filtered target vector and an $i^{th}$ first entry of the first codebook, $R_{CB2}(j)$ is a correlation between the filtered target vector and a $j^{th}$ entry of the second codebook, $E_{CB1}(i)$ is an energy of the $i^{th}$ entry of the first codebook and $E_{CB2}(i)$ is an energy of the $j^{th}$ entry of the second codebook, and $K_{CB1}^0$ is a number of first codebook entries in the first group and $K_{CB2}^0$ is a number of second codebook entries in the second group.

19. The system of claim 14, wherein the hardware-based audio coder comprises a processor.

20. The system of claim 14, wherein the hardware-based audio coder comprises dedicated hardware.

21. A fast search method of a mixed codebook for CELP encoding an audio/speech signal, the method comprising:

> determining a mixed codebook vector based on an incoming audio/speech signal, the mixed codebook vector comprising a sum of a first codebook entry from a first codebook and a second codebook entry from a second codebook, wherein the first and second codebooks are fixed codebooks;
> computing first correlations between a filtered target vector and filtered entries in the first codebook, wherein the filtered target vector is based on the incoming audio signal;
> determining a first group of highest first correlations;
> computing correlations between a filtered target vector and filtered entries in the second codebook;
> determining a second group of highest second correlations;
> computing a first criterion function of combinations of the first and second groups, wherein the first criterion function comprises a function of one of the first group of highest first correlations, one of the second group of highest second correlations and an energy of corresponding entries from the first codebook and the second codebook;

determining a third group of candidate correlations based on highest computed first criterion functions;
selecting the mixed codebook vector based on applying a second criterion function to the third group, wherein the mixed codebook vector corresponds to codebook entries from the first codebook and the second codebook associated with a highest value of the second criterion function;
generating an encoded audio signal based on the determined mixed codebook vector; and
transmitting a coded excitation index of the determined mixed codebook vector, wherein the determining and generating are performed using a hardware-based audio encoder;
wherein the first codebook comprises a pulse-like codebook and the second codebook comprises a noise-like codebook;

**22.** The method of claim 21, wherein:

the first criterion function is

$$Q(i,j) = \frac{[\,R_{CB1}(i) + R_{CB2}(j)\,]^2}{E_{CB1}(i) + E_{CB2}(j)} \quad ; \quad i = 0,1,...,K_{CB1}^0 - 1 \quad ; \quad j = 0,1,...,K_{CB2}^0 - 1 \quad ,$$

where $R_{CB1}(i)$ is a correlation between the filtered target vector and an $i^{th}$ first entry of the first codebook, $R_{CB2}(j)$ is a correlation between the filtered target vector and a $j^{th}$ entry of the second codebook, $E_{CB1}(i)$ is an energy of the $i^{th}$ entry of the first codebook and $E_{CB2}(i)$ is an energy of the $j^{th}$ entry of the second codebook, $K_{CB1}^0$ is a number of first codebook entries in the first group and $K_{CB2}^0$ is a number of second codebook entries in the second group; and
the second criterion function is

$$Q_k \;=\; \frac{[\,R_{CB1}(i_k) + R_{CB2}(j_k)]^2}{E_{CB1}(i_k) + 2\,\mathbf{z}_{CB1}(i_k)^T \mathbf{z}_{CB2}(j_k) + E_{CB2}(j_k)} \quad , \quad k = 0,1,...,K-1 \quad ,$$

where $\mathbf{z}_{CB1}(i_k)$ is a filtered vector of the $i^{th}$ entry of the first codebook and $\mathbf{z}_{CB2}(j_k)$ is a filtered vector of the $j^{th}$ entry of the second codebook, and K is a number of entries in the third group.

**Patentansprüche**

**1.** Verfahren zum CELP-Encodieren eines Audio-/Sprachsignals, wobei das Verfahren die folgenden Schritte umfasst:

Bestimmen eines gemischten Codebuchvektors beruhend auf einem ankommenden Audio-/Sprachsignal, wobei der gemischte Codebuchvektor eine Summe eines ersten Codebucheintrags aus einem ersten Codebuch und eines zweiten Codebucheintrags aus einem zweiten Codebuch aufweist, wobei das erste Codebuch impulsförmige Einträge aufweist und das zweite Codebuch rauschförmige Einträge aufweist;
Erzeugen eines encodierten Audiosignals beruhend auf dem bestimmten gemischten Codebuchvektor; und
Übertragen eines codierten Anregungsindex des bestimmten gemischten Codebuchvektors, wobei das Bestimmen und Erzeugen mittels eines hardwarebasierten Audioencoders durchgeführt werden;
wobei das erste und zweite Codebuch feste Codebücher sind.

**2.** Verfahren nach Anspruch 1, wobei das Bestimmen des gemischten Codebuchvektors aufweist:

Berechnen von ersten Korrelationen zwischen einem gefilterten Zielvektor und gefilterten Einträgen im ersten Codebuch, wobei der gefilterte Zielvektor auf dem ankommenden Audiosignal beruht;
Bestimmen einer ersten Gruppe von höchsten ersten Korrelationen;
Berechnen von Korrelationen zwischen einem gefilterten Zielvektor und gefilterten Einträgen im zweiten Codebuch;
Bestimmen einer zweiten Gruppe von höchsten zweiten Korrelationen; und

Berechnen einer ersten Kriteriumsfunktion von Kombinationen der ersten und zweiten Gruppe, wobei die erste Kriteriumsfunktion eine Funktion von einer der ersten Gruppe von höchsten ersten Korrelationen, einer der zweiten Gruppe von höchsten zweiten Korrelationen und einer Energie entsprechender Einträge aus dem ersten Codebuch und dem zweiten Codebuch aufweist.

3. Verfahren nach Anspruch 2, das ferner aufweist:

Bestimmen einer dritten Gruppe von Kandidatenkorrelationen beruhend auf höchsten berechneten ersten Kriteriumsfunktionen; und
Auswählen des gemischten Codebuchvektors beruhend auf dem Anwenden einer zweiten Kriteriumsfunktion auf die dritte Gruppe, wobei der gemischte Codebuchvektor Codebucheinträgen aus dem ersten Codebuch und dem zweiten Codebuch entspricht, die mit einem höchsten Wert der zweiten Kriteriumsfunktion verbunden sind.

4. Verfahren nach Anspruch 3, wobei:

die erste Kriteriumsfunktion

$$Q(i,j) = \frac{[\,R_{CB1}(i) + R_{CB2}(j)\,]^2}{E_{CB1}(i) + E_{CB2}(j)} \quad ; \quad i = 0, 1, \ldots, K_{CB1}^0 - 1 \quad ; \quad j = 0, 1, \ldots, K_{CB2}^0 - 1$$

ist, wobei $R_{CB1}(i)$ eine Korrelation zwischen dem gefilterten Zielvektor und einem i-ten ersten Eintrag des ersten Codebuchs ist, $R_{CB2}(j)$ eine Korrelation zwischen dem gefilterten Zielvektor und einem j-ten Eintrag des zweiten Codebuchs ist, $E_{CB1}(i)$ eine Energie des i-ten Eintrags des ersten Codebuchs ist und $E_{CB2}(i)$ eine Energie des j-ten Eintrags des zweiten Codebuchs ist, $K_{CB1}^0$ eine Anzahl von ersten Codebucheinträgen in der ersten Gruppe ist und $K_{CB2}^0$ eine Anzahl von zweiten Codebucheinträgen in der zweiten Gruppe ist; und
die zweite Kriteriumsfunktion

$$Q_k = \frac{[\,R_{CB1}(i_k) + R_{CB2}(j_k)]^2}{E_{CB1}(i_k) + 2\,\mathbf{z}_{CB1}(i_k)^T \mathbf{z}_{CB2}(j_k) + E_{CB2}(j_k)} \quad , \quad k = 0, 1, \ldots, K-1$$

ist, wobei $\mathbf{z}_{CB1}(i_k)$ ein gefilterter Vektor des i-ten Eintrags des ersten Codebuchs ist und $\mathbf{z}_{CB2}(j_k)$ ein gefilterter Vektor des j-ten Eintrags des zweiten Codebuchs ist, und K eine Anzahl von Einträgen in der dritten Gruppe ist.

5. Verfahren nach Anspruch 4, wobei das Auswählen des gemischten Codebuchvektors auf einer höchsten berechneten ersten Kriteriumsfunktion beruht.

6. Verfahren nach Anspruch 5, wobei die erste Kriteriumsfunktion

$$Q(i,j) = \frac{[\,R_{CB1}(i) + R_{CB2}(j)\,]^2}{E_{CB1}(i) + E_{CB2}(j)} \quad ; \quad i = 0, 1, \ldots, K_{CB1}^0 - 1 \quad ; \quad j = 0, 1, \ldots, K_{CB2}^0 - 1$$

ist, wobei $R_{CB1}(i)$ eine Korrelation zwischen dem gefilterten Zielvektor und einem i-ten ersten Eintrag des ersten Codebuchs ist, $R_{CB2}(j)$ eine Korrelation zwischen dem gefilterten Zielvektor und einem j-ten Eintrag des zweiten Codebuchs ist, $E_{CB1}(i)$ eine Energie des i-ten Eintrags des ersten Codebuchs ist und $E_{CB2}(i)$ eine Energie des j-ten Eintrags des zweiten Codebuchs ist, und $K_{CB1}^0$ eine Anzahl von ersten Codebucheinträgen in der ersten Gruppe ist und $K_{CB2}^0$ eine Anzahl von zweiten Codebucheinträgen in der zweiten Gruppe ist.

7. Verfahren nach Anspruch 2, das ferner das Berechnen von Energien der entsprechenden Einträge aus dem ersten Codebuch und dem zweiten Codebuch aufweist.

8. Verfahren nach Anspruch 2, wobei die Energie entsprechender Einträge aus dem ersten Codebuch und dem zweiten Codebuch in einem Speicher gespeichert wird.

9. Verfahren nach Anspruch 2, wobei die erste Gruppe mehr Einträge als die zweite Gruppe aufweist.

10. Verfahren nach Anspruch 1, das ferner aufweist:

   Anwenden einer ersten Gewichtungsfunktion auf den ersten Codebucheintrag; und
   Anwenden einer zweiten Gewichtungsfunktion auf den zweiten Codebucheintrag.

11. Verfahren nach Anspruch 10, wobei:

   die erste Gewichtungsfunktion eine Tiefpass-Filterfunktion aufweist; und
   die zweite Gewichtungsfunktion eine Hochpass-Filterfunktion aufweist.

12. Verfahren nach Anspruch 1, wobei der hardwarebasierte Audioencoder einen Prozessor aufweist.

13. Verfahren nach Anspruch 1, wobei der hardwarebasierte Audioencoder eine dedizierte Hardware aufweist.

14. System zum CELP-Encodieren eines Audio-/Sprachsignals, wobei das System Folgendes umfasst:

   einen hardwarebasierten Audiocodierer, der konfiguriert ist:

   einen gemischten Codebuchvektor beruhend auf einem ankommenden Audio-/Sprachsignal zu bestimmen, wobei der gemischte Codebuchvektor eine Summe eines ersten Codebucheintrags aus einem impulsförmigen Codebuch und eines zweiten Codebucheintrags aus einem rauschförmigen Codebuch aufweist, wobei das erste und zweite Codebuch feste Codebücher sind;
   ein encodiertes Audio-/Sprachsignal beruhend auf dem bestimmten gemischten Codebuchvektor zu erzeugen; und
   einen codierten Anregungsindex des bestimmten gemischten Codebuchvektors zu übertragen.

15. System nach Anspruch 14, wobei der hardwarebasierte Audiocodierer ferner konfiguriert ist:

   erste Korrelationen zwischen einem gefilterten Zielvektor und Einträgen im impulsförmigen Codebuch zu berechnen, wobei der gefilterte Zielvektor auf dem ankommenden Audiosignal beruht;
   eine erste Gruppe von höchsten ersten Korrelationen zu bestimmen;
   Korrelationen zwischen einem gefilterten Zielvektor und Einträgen im rauschförmigen Codebuch zu berechnen;
   eine zweite Gruppe von höchsten zweiten Korrelationen zu bestimmen; und
   eine erste Kriteriumsfunktion von Kombinationen der ersten und zweiten Gruppe zu berechnen, wobei die erste Kriteriumsfunktion eine Funktion von einer der ersten Gruppe von höchsten ersten Korrelationen, einer der zweiten Gruppe von höchsten zweiten Korrelationen und einer Energie entsprechender Einträge auf dem impulsförmigen Codebuch und dem rauschförmigen Codebuch aufweist.

16. System nach Anspruch 15, das ferner einen Speicher aufweist, der konfiguriert ist, Werte der Energie entsprechender Einträge aus dem impulsförmigen Codebuch und dem rauschförmigen Codebuch zu speichern.

17. System nach Anspruch 15, wobei der hardwarebasierte Audiocodierer ferner konfiguriert ist, den gemischten Codebuchvektor beruhend auf einer höchsten berechneten ersten Kriteriumsfunktion auszuwählen.

18. System nach Anspruch 15, wobei die erste Kriteriumsfunktion

$$Q(i,j) = \frac{[\, R_{CB1}(i) + R_{CB2}(j)\,]^2}{E_{CB1}(i) + E_{CB2}(j)} \quad ; \quad i = 0, 1, ..., K^0_{CB1} - 1 \quad ; \quad j = 0, 1, ..., K^0_{CB2} - 1$$

ist, wobei R$_{CB1}$(i) eine Korrelation zwischen dem gefilterten Zielvektor und einem i-ten ersten Eintrag des ersten Codebuchs ist, R$_{CB2}$(j) eine Korrelation zwischen dem gefilterten Zielvektor und einem j-ten Eintrag des zweiten Codebuchs ist, E$_{CB1}$(i) eine Energie des i-ten Eintrags des ersten Codebuchs ist und E$_{CB2}$(i) eine Energie des j-ten Eintrags des zweiten Codebuchs ist, und $K_{CB1}^{0}$ eine Anzahl von ersten Codebucheinträgen in der ersten Gruppe ist und $K_{CB2}^{0}$ eine Anzahl von zweiten Codebucheinträgen in der zweiten Gruppe ist.

19. System nach Anspruch 14, wobei der hardwarebasierte Audiocodierer einen Prozessor aufweist.

20. System nach Anspruch 14, wobei der hardwarebasierte Audiocodierer eine dedizierte Hardware aufweist.

21. Schnelles Such verfahren eines gemischten Codebuchs zum CELP-Encodieren eines Audio-/Sprachsignals, wobei das Verfahren die folgenden Schritte umfasst:

Bestimmen eines gemischten Codebuchvektors beruhend auf einem ankommenden Audio-/Sprachsignal, wobei der gemischte Codebuchvektor eine Summe eines ersten Codebucheintrags aus einem ersten Codebuch und eines zweiten Codebucheintrags aus einem zweiten Codebuch aufweist, wobei das erste und zweite Codebuch feste Codebücher sind;
Berechnen von ersten Korrelationen zwischen einem gefilterten Zielvektor und gefilterten Einträgen im ersten Codebuch, wobei der gefilterte Zielvektor auf dem ankommenden Audiosignal beruht;
Bestimmen einer ersten Gruppe von höchsten ersten Korrelationen;
Berechnen von Korrelationen zwischen einem gefilterten Zielvektor und gefilterten Einträgen im zweiten Codebuch;
Bestimmen einer zweiten Gruppe von höchsten zweiten Korrelationen;
Berechnen einer ersten Kriteriumsfunktion von Kombinationen der ersten und zweiten Gruppe, wobei die erste Kriteriumsfunktion eine Funktion von einer der ersten Gruppe von höchsten ersten Korrelationen, einer der zweiten Gruppe von höchsten zweiten Korrelationen und einer Energie entsprechender Einträge aus dem ersten Codebuch und dem zweiten Codebuch aufweist;
Bestimmen einer dritten Gruppe von Kandidatenkorrelationen beruhend auf höchsten berechneten ersten Kriteriumsfunktionen;
Auswählen des gemischten Codebuchvektors beruhend auf dem Anwenden einer zweiten Kriteriumsfunktion auf die dritte Gruppe, wobei der gemischte Codebuchvektor Codebucheinträgen aus dem ersten Codebuch und dem zweiten Codebuch entspricht, die mit einem höchsten Wert der zweiten Kriteriumsfunktion verbunden sind;
Erzeugen eines encodierten Audiosignals beruhend auf dem bestimmten gemischten Codebuchvektor; und
Übertragen eines codierten Anregungsindex des bestimmten gemischten Codebuchvektors, wobei das Bestimmen und Erzeugen mittels eines hardwarebasierten Audioencoders durchgeführt werden;
wobei das erste Codebuch ein impulsförmiges Codebuch aufweist und das zweite Codebuch ein rauschförmiges Codebuch aufweist.

22. Verfahren nach Anspruch 21, wobei:

die erste Kriteriumsfunktion

$$Q(i,j) = \frac{[\, R_{CB1}(i) + R_{CB2}(j) \,]^{2}}{E_{CB1}(i) + E_{CB2}(j)} \quad ; \quad i = 0,1,...,K_{CB1}^{0} - 1 \quad ; \quad j = 0,1,...,K_{CB2}^{0} - 1$$

ist, wobei R$_{CB1}$(i) eine Korrelation zwischen dem gefilterten Zielvektor und einem i-ten ersten Eintrag des ersten Codebuchs ist, R$_{CB2}$(j) eine Korrelation zwischen dem gefilterten Zielvektor und einem j-ten Eintrag des zweiten Codebuchs ist, E$_{CB1}$(i) eine Energie des i-ten Eintrags des ersten Codebuchs ist und E$_{CB2}$(i) eine Energie des j-ten Eintrags des zweiten Codebuchs ist, $K_{CB1}^{0}$ eine Anzahl von ersten Codebucheinträgen in der ersten Gruppe ist und $K_{CB2}^{0}$ eine Anzahl von zweiten Codebucheinträgen in der zweiten Gruppe ist; und
die zweite Kriteriumsfunktion

$$Q_k \;=\; \frac{[\,R_{CB1}(i_k)+R_{CB2}(j_k)\,]^2}{E_{CB1}(i_k)+2\,\mathbf{z}_{CB1}(i_k)^T\,\mathbf{z}_{CB2}(j_k)+E_{CB2}(j_k)} \quad,\quad k=0,1,...,K-1$$

ist, wobei $\mathbf{z}_{CB1}(i_k)$ ein gefilterter Vektor des i-ten Eintrags des ersten Codebuchs ist und $\mathbf{z}_{CB2}(j_k)$ ein gefilterter Vektor des j-ten Eintrags des zweiten Codebuchs ist, und K eine Anzahl von Einträgen in der dritten Gruppe ist.

**Revendications**

1. Procédé de codage CELP d'un signal audio/vocal, le procédé comprenant :

   la détermination d'un vecteur de guide mixte de codification sur la base d'un signal audio/vocal entrant, le vecteur de guide mixte de codification comprenant une somme d'une première entrée de guide de codification provenant d'un premier guide de codification et d'une seconde entrée de guide de codification provenant d'un second guide de codification, dans lequel le premier guide de codification comprend des entrées de type à impulsions et le second guide de codification comprend des entrées de type bruit ;
   la génération d'un signal audio codé sur la base du vecteur de guide mixte de codification déterminé ; et
   la transmission d'un indice d'excitation codé du vecteur de guide mixte de codification déterminé, dans lequel la détermination et la génération sont effectuées à l'aide d'un codeur audio basé sur du matériel ;
   dans lequel les premier et second guides de codification sont des guides de codification fixes.

2. Procédé selon la revendication 1, dans lequel la détermination du vecteur de guide mixte de codification comprend :

   le calcul des premières corrélations entre un vecteur cible filtré et des entrées filtrées dans le premier guide de codification, dans lequel le vecteur cible filtré est basé sur le signal audio entrant ;
   la détermination d'un premier groupe de premières corrélations les plus élevées ;
   le calcul des corrélations entre un vecteur cible filtré et des entrées filtrées dans le second guide de codification ;
   la détermination d'un deuxième groupe de secondes corrélations les plus élevées ; et
   le calcul d'une première fonction de critère de combinaisons des premier et deuxième groupes, dans lequel la première fonction de critère comprend une fonction d'un du premier groupe des premières corrélations les plus élevées, d'un du deuxième groupe des secondes corrélations les plus élevées et une énergie d'entrées correspondantes à partir du premier guide de codification et du second guide de codification.

3. Procédé selon la revendication 2, comprenant en outre :

   la détermination d'un troisième groupe de corrélations candidates sur la base des premières fonctions de critères calculées les plus élevées ; et
   la sélection du vecteur de guide mixte de codification sur la base de l'application d'une seconde fonction de critère au troisième groupe, dans lequel le vecteur de guide mixte de codification correspond à des entrées de guide de codification provenant du premier guide de codification et du second guide de codification associées à une valeur la plus élevée de la seconde fonction de critère.

4. Procédé selon la revendication 3, dans lequel :

   la première fonction de critère est :

$$Q(i,j)=\frac{[\,R_{CB1}(i)+R_{CB2}(j)\,]^2}{E_{CB1}(i)+E_{CB2}(j)} \quad;\quad i=0,1,...,K_{CB1}^{0}-1 \quad;\quad j=0,1,...,K_{CB2}^{0}-1 \quad,$$

   où $R_{CB1}(i)$ est une corrélation entre le vecteur cible filtré et une $i^{\text{ème}}$ première entrée du premier guide de codification, $R_{CB2}(j)$ est une corrélation entre le vecteur cible filtré et une $j^{\text{ème}}$ entrée du second guide de codification, $E_{CB1}(i)$ est une énergie de la $i^{\text{ème}}$ entrée du premier guide de codification et $E_{CB2}(i)$ est une énergie

de la $j^{\text{ème}}$ entrée du second guide de codification, $K_{CB1}^0$ est un nombre de premières entrées de guide de codification dans le premier groupe et $K_{CB2}^0$ est un nombre de secondes entrées de guide de codification dans le deuxième groupe ; et

la seconde fonction de critère est :

$$Q_k = \frac{[R_{CB1}(i_k) + R_{CB2}(j_k)]^2}{E_{CB1}(i_k) + 2\,\mathbf{z}_{CB1}(i_k)^T \mathbf{z}_{CB2}(j_k) + E_{CB2}(j_k)} \quad,\quad k = 0, 1, ..., K-1 \quad,$$

où $z_{CB1}(i_k)$ est un vecteur filtré de la $i^{\text{ème}}$ entrée du premier guide de codification et $z_{CB2}(j_k)$ est un vecteur filtré de la $j^{\text{ème}}$ entrée du second guide de codification, et K est un nombre d'entrées dans le troisième groupe.

5. Procédé selon la revendication 4, dans lequel sélectionner le vecteur de guide mixte de codification basé sur une première fonction de critère calculée la plus élevée.

6. Procédé selon la revendication 5, dans lequel la première fonction de critère est :

$$Q(i,j) = \frac{[R_{CB1}(i) + R_{CB2}(j)]^2}{E_{CB1}(i) + E_{CB2}(j)} \quad;\quad i = 0, 1, ..., K_{CB1}^0 - 1 \quad;\quad j = 0, 1, ..., K_{CB2}^0 - 1$$

où $R_{CB1}(i)$ est une corrélation entre le vecteur cible filtré et une $i^{\text{ème}}$ première entrée du premier guide de codification, $R_{CB2}(j)$ est une corrélation entre le vecteur cible filtré et une $j^{\text{ème}}$ entrée du second guide de codification, $E_{CB1}(i)$ est une énergie de la $i^{\text{ème}}$ entrée du premier guide de codification et $E_{CB2}(i)$ est une énergie de la $j^{\text{ème}}$ entrée du second guide de codification, et $K_{CB1}^0$ est un nombre de premières entrées de guide de codification dans le premier groupe et $K_{CB2}^0$ est un nombre de secondes entrées de guide de codification dans le deuxième groupe.

7. Procédé selon la revendication 2, comprenant en outre le calcul d'énergies des entrées correspondantes provenant du premier guide de codification et du second guide de codification.

8. Procédé selon la revendication 2, dans lequel l'énergie des entrées correspondantes provenant du premier guide de codification et du second guide de codification est stockée dans une mémoire.

9. Procédé selon la revendication 2, dans lequel le premier groupe comprend plus d'entrées que le deuxième groupe.

10. Procédé selon la revendication 1, comprenant en outre :

l'application d'une première fonction d'accentuation à la première entrée du guide de codification ; et
l'application d'une seconde fonction d'accentuation à la seconde entrée du guide de codification.

11. Procédé selon la revendication 10, dans lequel :

la première fonction d'accentuation comprend une fonction de filtre passe-bas ; et
la seconde fonction d'accentuation comprend une fonction de filtre passe-haut.

12. Procédé selon la revendication 1, dans lequel le codeur audio basé sur du matériel comprend un processeur.

13. Procédé selon la revendication 1, dans lequel le codeur audio basé sur du matériel comprend du matériel dédié.

14. Système de codage CELP d'un signal audio/vocal, le système comprenant :

un codeur audio basé sur du matériel configuré pour :

déterminer un vecteur de guide mixte de codification sur la base d'un signal audio/vocal entrant, le vecteur de guide mixte de codification comprenant une somme d'une première entrée de guide de codification provenant d'un guide de codification de type à impulsions et d'une seconde entrée de guide de codification provenant d'un guide de codification de type bruit,

dans lequel les premier et second guides de codification sont des guides de codification fixes ;

générer un signal audio/vocal codé sur la base du vecteur de guide mixte de codification déterminé ; et

transmettre un indice d'excitation codé du vecteur de guide mixte de codification déterminé.

**15.** Système selon la revendication 14, dans lequel le codeur audio basé sur du matériel est configuré en outre pour :

calculer des premières corrélations entre un vecteur cible filtré et des entrées dans le guide de codification de type à impulsions, dans lequel le vecteur cible filtré est basé sur le signal audio entrant ;

déterminer un premier groupe de premières corrélations les plus élevées ;

calculer des corrélations entre un vecteur cible filtré et des entrées dans le guide de codification de type bruit ;

déterminer un deuxième groupe de secondes corrélations les plus élevées ; et

calculer une première fonction de critère des combinaison des premier et deuxième groupes, dans lequel la première fonction de critère comprend une fonction d'un du premier groupe des premières corrélations les plus élevées, d'un du deuxième groupe des secondes corrélations les plus élevées et une énergie d'entrées correspondantes à partir du guide de codification de type à impulsions et du guide de codification de type bruit.

**16.** Système selon la revendication 15, comprenant en outre une mémoire configurée pour stocker des valeurs de l'énergie d'entrées correspondantes provenant du guide de codification de type à impulsions et du guide de codification de type bruit.

**17.** Système selon la revendication 15, dans lequel le codeur audio basé sur du matériel est configuré en outre pour sélectionner le vecteur de guide mixte de codification sur la base d'une première fonction de critère calculée la plus élevée.

**18.** Système selon la revendication 15, dans lequel la première fonction de critère est :

$$ Q(i,j) = \frac{[\,R_{CB1}(i) + R_{CB2}(j)\,]^2}{E_{CB1}(i) + E_{CB2}(j)} \;\; ; \;\; i = 0,1,...,K^0_{CB1} - 1 \;\; ; \;\; j = 0,1,...,K^0_{CB2} - 1 $$

où $R_{CB1}(i)$ est une corrélation entre le vecteur cible filtré et une $i^{ème}$ première entrée du premier guide de codification, $R_{CB2}(j)$ est une corrélation entre le vecteur cible filtré et une $j^{ème}$ entrée du second guide de codification, $E_{CB1}(i)$ est une énergie de la $i^{ème}$ entrée du premier guide de codification et $E_{CB2}(i)$ est une énergie de la $j^{ème}$ entrée du second guide de codification, et $K^0_{CB1}$ est un nombre de premières entrées de guide de codification dans le premier groupe et $K^0_{CB2}$ est un nombre de secondes entrées de guide de codification dans le deuxième groupe.

**19.** Système selon la revendication 14, dans lequel le codeur audio basé sur du matériel comprend un processeur.

**20.** Système selon la revendication 14, dans lequel le codeur audio basé sur du matériel comprend du matériel dédié.

**21.** Procédé de recherche rapide d'un guide mixte de codification de codage CELP d'un signal audio/vocal, le procédé comprenant :

déterminer un vecteur de guide mixte de codification sur la base d'un signal audio/vocal entrant, le vecteur de guide mixte de codification comprenant une somme d'une première entrée de guide de codification provenant d'un premier guide de codification et d'une seconde entrée de guide de codification provenant d'un second guide de codification, dans lequel les premier et second guides de codification sont des guides de codification fixes ;

calculer des premières corrélations entre un vecteur cible filtré et des entrées filtrées dans le premier guide de codification, dans lequel le vecteur cible filtré est basé sur le signal audio entrant ;

déterminer un premier groupe de premières corrélations les plus élevées ;

**EP 2 805 324 B1**

calculer des corrélations entre un vecteur cible filtré et des entrées filtrées dans le second guide de codification ;
déterminer un deuxième groupe de secondes corrélations les plus élevées ;
calculer une première fonction de critère de combinaisons des premier et deuxième groupes, dans lequel la première fonction de critère comprend une fonction d'un du premier groupe des premières corrélations les plus élevées, d'un du deuxième groupe des secondes corrélations les plus élevées et une énergie d'entrées correspondantes à partir du premier guide de codification et du second guide de codification ;
déterminer un troisième groupe de corrélations candidates sur la base des premières fonctions de critères calculées les plus élevées ;
sélectionner le vecteur de guide mixte de codification sur la base de l'application d'une seconde fonction de critère au troisième groupe, dans lequel le vecteur de guide mixte de codification correspond à des entrées de guide de codification provenant du premier guide de codification et du second guide de codification associées à une valeur la plus élevée de la seconde fonction de critère ;
générer un signal audio codé sur la base du vecteur de guide mixte de codification déterminé ; et
transmettre un indice d'excitation codé du vecteur de guide mixte de codification déterminé, dans lequel la détermination et la génération sont effectuées à l'aide d'un codeur audio basé sur du matériel ;
dans lequel le premier guide de codification comprend un guide de codification de type à impulsions et le second guide de codification comprend un guide de codification de type bruit.

22. Procédé selon la revendication 21, dans lequel :

la première fonction de critère est :

$$Q(i,j) = \frac{[R_{CB1}(i) + R_{CB2}(j)]^2}{E_{CB1}(i) + E_{CB2}(j)} \quad ; \quad i = 0, 1, ..., K_{CB1}^0 - 1 \quad ; \quad j = 0, 1, ..., K_{CB2}^0 - 1$$

où $R_{CB1}(i)$ est une corrélation entre le vecteur cible filtré et une $i^{\text{ème}}$ première entrée du premier guide de codification, $R_{CB2}(j)$ est une corrélation entre le vecteur cible filtré et une $j^{\text{ème}}$ entrée du second guide de codification, $E_{CB1}(i)$ est une énergie de la $i^{\text{ème}}$ entrée du premier guide de codification et $E_{CB2}(i)$ est une énergie de la $j^{\text{ème}}$ entrée du second guide de codification, $K_{CB1}^0$ est un nombre de premières entrées de guide de codification dans le premier groupe et $K_{CB2}^0$ est un nombre de secondes entrées de guide de codification dans le deuxième groupe ; et
la seconde fonction de critère est :

$$Q_k = \frac{[R_{CB1}(i_k) + R_{CB2}(j_k)]^2}{E_{CB1}(i_k) + 2\,\mathbf{z}_{CB1}(i_k)^T \mathbf{z}_{CB2}(j_k) + E_{CB2}(j_k)} \quad , \quad k = 0, 1, ..., K-1$$

où $z_{CB1}(i_k)$ est un vecteur filtré de la $i^{\text{ème}}$ entrée du premier guide de codification et $z_{CB2}(j_k)$ est un vecteur filtré de la $j^{\text{ème}}$ entrée du second guide de codification, et K est un nombre d'entrées dans le troisième groupe.

*FIG. 1*

*FIG. 2*

**FIG. 3**

**FIG. 4**

Coded Excitation Codebook or Fixed
Codebook for CELP coding

501

503

$G_c$

502
Codebook
Vector

## FIG. 5

Coded Excitation Codebook or Fixed
Codebook for CELP coding

601

603

$G_c$

602
Codebook
Vector

## FIG. 6

Coded Excitation Codebook or Fixed
Codebook for CELP coding
701

**FIG. 7**

Coded Excitation Codebook or Fixed
Codebook for CELP coding
801

**FIG. 8**

Coded Excitation Codebook or Fixed
Codebook for CELP coding
901

*FIG. 9*

Coded Excitation Codebook or Fixed
Codebook for CELP coding
1001

*FIG. 10*

Coded Excitation Codebook or Fixed
Codebook for CELP coding
1101

**FIG. 11**

Coded Excitation Codebook or Fixed
Codebook for CELP coding
1201

**FIG. 12**

**FIG. 13**

**FIG. 14**

1500

```
                    ( START )
                         |
                         v
1502  +--------------------------------------+
      | Compute Correlation Between Filtered |
      | Codebook Vector and Filtered Target  |
      | Vector for Pulse Codebook and Noise  |
      | Codebook                             |
      +--------------------------------------+
                         |
                         v
1504  +--------------------------------------+
      | Determine Energy of Each Filtered    |
      | Codebook Vector for for Pulse        |
      | Codebook and Noise Codebook          |
      +--------------------------------------+
                         |
                         v
1506  +--------------------------------------+
      | Determine First Group of Highest     |
      | Correlations of Filtered Target      |
      | Vector and Filtered Pulse Codebook   |
      | Vector                               |
      +--------------------------------------+
                         |
                         v
1508  +--------------------------------------+
      | Determine Second Group of Highest    |
      | Correlations of Filtered Target      |
      | Vector and Filtered Pulse Noise      |
      | Vector                               |
      +--------------------------------------+
                         |
                         v
1510  +--------------------------------------+
      | Apply First Criterion Function to    |
      | Combinations of First and Second     |
      | Groups                               |
      +--------------------------------------+
                         |
                         v
1512  +--------------------------------------+
      | Determine Third Group of Pulse Vector|
      | and Noise Vector Combinations Based  |
      | on Highest First Criterion Function  |
      +--------------------------------------+
                         |
                         v
1514  +--------------------------------------+
      | Apply Second Criterion Function to   |
      | Third Group of Pulse Vector and Noise|
      | Vector Combinations                  |
      +--------------------------------------+
                         |
                         v
1516  +--------------------------------------+
      | Select Indices of Pulse Vector and   |
      | Noise Vector Combinations Having     |
      | Highest Second Criterion             |
      +--------------------------------------+
                         |
                         v
                    (  END  )
```

*FIG. 15a*

1550

START

1552

Identify out of all the $K_{CB1}$ possible CB 1 vectors and out of all the $K_{CB2}$ possible CB 2 vectors

1554

Compute energy terms $E_{CB1}$ and $E_{CB2}$

1556

Compute and choose $K$ possible combinations of the mixed codebook contributions.

1558

Select vector from K possible combinations of mixed codebook contributions.

END

*FIG. 15b*

**FIG. 16**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Strategies to improve the performance of very low bit rate speech coders and application to a variable rate 1.2 kb/s codex. **DE LAMARE R C et al.** IEE PROCEEDINGS: VISION, IMAGE AND SIGNAL PROCESSING. INSTITUTION OF ELECTRICAL ENGINEERS, 28 February 2005, vol. 152, 74-86